# EUROPÄISCHE PATENTSCHRIFT

(11) **EP 3 158 636 B1**
(45) Veröffentlichungstag und Bekanntmachung des Hinweises auf die Patenterteilung: **28.10.2020**
(21) Anmeldenummer: 15732569.7
(22) Anmeldetag: 18.06.2015
(51) Int. Cl.: H02M 7/5387, H02M 1/00

(54) **STROMRICHTER UND COMPUTERPROGRAMM**
ELECTRONIC POWER CONVERTER AND COMPUTER PROGRAM
CONVERTISSEUR ET PROGRAMME INFORMATIQUE

(30) Priorität: 20.06.2014 DE 102014108667
(43) Veröffentlichungstag der Anmeldung: 26.04.2017
(73) Patentinhaber: Technische Universität Braunschweig, 38106 Braunschweig (DE)
(72) Erfinder: SCHUMACHER, Walter, 38312 Ohrum (DE); HOMANN, Michael, 38533 Vordorf (DE)
(74) Vertreter: Gramm, Lins & Partner Patent- und Rechtsanwälte PartGmbB
(86) Internationale Anmeldenummer: PCT/EP2015/063718
(87) Internationale Veröffentlichungsnummer: WO 2015/193439

(56) Entgegenhaltungen:
- EP-A2- 1 049 241
- DE-A1-102012 210 656
- US-A1- 2002 196 645
- US-A1- 2008 266 918
- US-A1- 2014 042 938
- US-B1- 6 201 720
- Zhenyu Yu: "Digital Signal Processing Solutions Space-Vector PWM With TMS320C24x/F24x Using Hardware and Software Determined Switching Patterns", , 31. März 1999 (1999-03-31), XP055213491, Gefunden im Internet: URL:http://www.ti.com/lit/an/spra524/spra5 24.pdf [gefunden am 2015-09-15]

## Beschreibung

Die Erfindung betrifft einen mehrphasigen Stromrichter zur Abgabe von mehrphasigem Wechselstrom gemäß den Merkmalen des Anspruchs 1. Die Erfindung betrifft außerdem ein Computerprogramm gemäß Anspruch 14.

Elektrische Antriebe werden heutzutage aus geschalteten Leistungsteilen versorgt, die üblicherweise mit pulsweiten-modulierten Signalen (PWM-Signale) angesteuert werden. Hierzu werden Stromrichter verwendet, die für jede Phase der elektrischen Maschine, die zu steuern ist, einen über wenigstens zwei in Halbbrückenschaltung geschaltete Halbleiterschalter gesteuerten Leistungsausgang aufweisen. Zur Erzeugung der Ansteuersignale der Halbleiterschalter gibt es im Stand der Technik verschiedene Möglichkeiten, z.B. die Ausgabe eines PWM-Signals mit einer festen Schaltfrequenz mit Standardbausteinen in Digitaltechnik. Dazu können die Bausteine mit Steuerwörtern mit mehreren Bit Wortbreite beschrieben werden. Die Digitallogik erzeugt daraus die pulsweiten-modulierten Ansteuersignale für die Halbleiterschalter. Nachteilig ist hierbei, dass aufgrund der synchronen Logik die Schaltmuster nur vor zwei Zeitpunkten am Beginn und in der Mitte der Schaltfrequenzperiode geändert werden können.

Vorschläge zur Steuerung elektrischer Maschinen gehen z.B. aus der DE 10 2012 206 323 A1 oder der Dissertation von Jonathan Bernard Bradshaw hervor, "Bit-Streams Control of Doubly Fed Induction Generators", 07. März 2012, University of Auckland, Neuseeland. Aus der US 2002/0196645 A1 ist eine Steuereinrichtung eines mehrphasigen Stromrichters bekannt. Aus der US 6,201,720 B1 sind Einrichtungen und Verfahren für die Steuerung unterbrechungsfreier Stromversorgungen in der Raumzeigerebene bekannt. Aus der EP 1 049 241 A2 ist eine modifizierte Raumvektor-Pulsbreitenmodulationstechnik zur Reduzierung von Gleichspannungs-Rippleeffekten in Spannungsinvertern bekannt.

Ein weiterer Nachteil bekannter Stromrichter zur Steuerung elektrischer Maschinen besteht darin, dass die PWM-Signale mit fester Schaltfrequenz erzeugt werden, die üblicherweise im für Menschen wahrnehmbaren Bereich liegt. Daher geht der Betrieb der elektrischen Maschine dann mit einem häufig störenden, gleichförmigen Nebengeräusch einher, z.B. einem hochfrequenten Pfeifen. Legt man die Schaltfrequenz außerhalb des hörbaren Bereichs, entstehen erhöhte Schaltverluste.

Ein weiterer Nachteil bekannter Stromrichter besteht darin, dass bei der üblichen digitalen Ausführung die Pulsweitenmodulation in einer offenen Schleife erfolgt. Die Ansteuersignale für die Halbleiterschalter werden an das Leistungsteil übertragen und durch diverse Effekte unterscheiden sich die an der Last, d.h. an der elektrischen Maschine, tatsächlich anliegenden Spannungszeitflächen von den Sollwerten am Eingang des Stromrichters. So geht der Betrag der am Leistungsteil anliegenden Versorgungsspannung, beeinflusst durch Schwankungen durch Reste der Eingangswechselspannung vom Gleichrichter, Spannungsanhebung bei generatorischem Betrieb der Last usw., in voller Höhe multiplikativ ein. Im Stand der Technik wird versucht, solche Effekte durch Messungen und als Vorwärtsaufschaltung in der Modulation zu berücksichtigen. Es kommt hinzu, dass die Halbleiterschalter Spannungsabfälle aufweisen, sobald sie Strom führen. Diese sind für aktive Schalter und in Dioden im Allgemeinen verschieden und von der Chip-Temperatur abhängig. Solche Effekte können nicht ohne Weiteres in einer Vorwärtsaufschaltung mit festen Werten kompensiert werden. Wesentliche Spannungsfehler entstehen durch die Totzeiten, die nach der Berechnung der Schaltzeitpunkte zwischen dem Abschalten eines Halbleiterschalters einer Halbbrücke und dem Einschalten des anderen Halbleiterschalters der Halbbrücke eingefügt werden müssen, um Kurzschlüsse der Gleichstromversorgung zu verhindern. Je nach Stromvorzeichen ändert sich auch das Vorzeichen der fehlenden Spannungszeitfläche. Dies führt zu erheblichen nichtlinearen Verzerrungen der erzeugten effektiven Spannungen und ist nur zum Teil durch eine Aufschaltung mit einer Stromabhängigen Tabelle zu kompensieren, da die tatsächlichen Schaltzeiten der Halbleiter, die temperaturabhängig sind und Exemplarstreuungen unterliegen, in die Fehlspannungen eingehen. Zusätzlich sind die Schaltflanken der Spannung nicht ideal, sondern bilden Spannungsrampen, deren Steilheit wiederum vom Strombetrag abhängt. Auch dieser Effekt geht als Fehler in die Ausgangsspannung ein.

Der Erfindung liegt die Aufgabe zugrunde, solche nachteiligen Effekte bei bekannten Stromrichtern zu überwinden.

Die Aufgabe wird durch einen mehrphasigen Stromrichter gemäß Anspruch 1 gelöst. Der Stromrichter weist für jede Phase des mehrphasigen Wechselstroms einen über wenigstens zwei in Halbbrückenschaltung geschaltete Halbleiterschalter gesteuerten Leistungsausgang auf, wobei der Stromrichter eine Steuereinrichtung aufweist, die zur Verarbeitung eines der Steuereinrichtung als Eingangssignal zugeführten Sollwertsignals in Form jeweils eines ein Bit oder mehrere Bits breiten Bitstroms für jede Phase eingerichtet ist, wobei die Steuereinrichtung zur Erzeugung von Betätigungssignalen der Halbleiterschalter in Abhängigkeit von den als Eingangssignal zugeführten Bitströmen mittels Raumzeigermodulation eingerichtet ist. An jedem Leistungsausgang steht dann eine Phase des Wechselstroms zur Verfügung.

Als Bitstrom wird dabei eine zeitlich aufeinander folgende Sequenz von Bits verstanden, bei der die darin enthaltene Information nicht durch einen Abtastwert repräsentiert wird, sondern durch einen Mittelwert über eine Folge von aufeinander folgenden Bits des Bitstroms. Die Information kann z.B. durch Tiefpassfilterung über eine Folge von aufeinander folgenden Bits des Bitstroms gewonnen werden. Ein Bitstrom kann dabei ein Bit oder mehrere Bits, z.B. 2 bis 6 Bits, breit sein. Solche Bitströme können z.B. durch Delta-Sigma-Modulation erzeugt werden.

Die Erfindung hat den Vorteil, dass ein aktuelles als Sollwert zugeführtes Eingangssignal quasi verzögerungsfrei in das PWM-Signal umgesetzt werden kann. Damit kann die Regelung quasi analog in Echtzeit mit Mitteln der Digitaltechnik erfolgen. Die Erfindung bietet damit eine verbesserte Dynamik und Genauigkeit insbesondere bei sogenannter sensorloser Regelung elektrischer Maschinen. Dies wird möglich durch eine Kombination von Bitströmen als Eingangssignale, z.B. in Form von Delta-Sigma-Bitströmen, mit einer Verarbeitung mittels Raumzeigermodulation. Diese Kombination bietet besondere Synergieeffekte für die Steuerung mehrphasiger elektrischer Maschinen, insbesondere elektrischen Antrieben wie Drehstrommotoren. Die Nutzung von Bitströmen als Eingangssignal erlaubt eine sehr hochfrequente Taktung, die um Größenordnungen höher liegt als die als Ausgangssignale bereitgestellten PWM-Signale. Übliche Delta-Sigma-Modulatoren können z.B. mit Taktraten im Bereich von 10 MHz bis hin zu mehreren 10 MHz betrieben werden. Dies liegt um mindestens 3 Größenordnungen höher als Frequenzen üblicher PWM-Signale, die z.B. im Bereich von 4 KHz liegen.

Gemäß der vorliegenden Erfindung werden die Ansteuersignale für das mehrphasige Leistungsteil aus den als Eingangssignal zugeführten Bitströmen, die jeweils ein Bit oder mehrere Bits breit sind, generiert. Der Mittelwert solcher Bitströme entspricht dabei dem gewünschten Spannungswert oder Stromwert, der durch die Halbleiterschalter am Leistungsausgang bereitgestellt werden soll. Durch Einsatz der Raumzeigermodulation, bei der gezielt auch sogenannte Nullvektoren erzeugt werden, die die Spannung Null an den Leistungsausgang anlegen, kann eine besonders effektive Steuerung von elektrischen Maschinen realisiert werden. Da die Bitströme sehr hochfrequent gegenüber einer digitalen Regelung sind, kann eine Schaltflanke an den Leistungsausgängen auch noch durch Signalanteile der Eingangssignale modifiziert werden, die erst unmittelbar vor Auslösen des Schaltvorgangs im Stromrichter bzw. dessen Steuereinrichtung eintreffen.

Ein weiterer Vorteil der Erfindung besteht darin, dass prinzipbedingt keine feste Taktfrequenz für die Ausgangssignale an den Leistungsausgängen, d.h. für das PWM-Signal, erforderlich ist. Vielmehr erlaubt die vorliegende Erfindung eine freilaufende Erzeugung der Ausgangssignale an den Leistungsausgängen ohne feste Taktfrequenz. Hierdurch kann die eingangs genannte Geräuschproblematik gelöst werden. Durch nach einem Zufallsmuster oder Quasizufallsmuster wechselnde Frequenzen der Ausgangssignale entsteht kein gleichförmiges Geräusch mehr, sondern ein wechselndes Geräusch, z.B. ein Rauschen, was als weniger störend wahrgenommen wird. Die Erfindung bietet damit eine sehr angenehme Akustik bei niedrigen bis mittleren Schaltfrequenzen. Diese sind aus Gründen der Energieeffizienz anzustreben.

Die Raumzeigermodulation beruht darauf, dass innerhalb einer Schaltfrequenzperiode die Einschaltzeiten für die Spannungsraumzeiger so verteilt werden, dass in der ersten Halbperiode ausgehend vom ersten Nullvektor (000) ein Schaltvektor geschaltet wird, der nur einen Schalter auf der positiven Seite einer Halbbrücke einschaltet (V1: Schaltvektor mit nur einer 1), dann ein Schaltvektor geschaltet wird, der zwei verschiedene Halbbrücken einschaltet (V2: Schaltvektor mit zwei Einsen), danach der zweite Nullvektor (111), dann wieder V2, V1 und der erste Nullvektor.

Es ergibt sich somit folgender Schaltzyklus: 000 - V1 - V2 - 111 - V2 - V1 - 000.

Die Schaltvektoren V1 und V2 ergeben sich bei der Raumzeigermodulation als die dem Soll-Spannungsraumzeiger im Sechseck der möglichen einstellbaren Schaltvektoren winkelmäßig benachbarten Schaltvektoren. Die Einschaltzeiten der beiden Schaltvektoren V1 und V2 ergeben sich aus geometrischen Projektionen des Soll-Spannungsraumzeigers auf die benachbarten Schaltvektoren.

Um zu vermeiden, dass, sobald ein aktiver Schaltvektor (V1, V2) geschaltet wurde, die Information verloren geht, welcher Nullvektor zuletzt geschaltet wurde und ob als nächstes beim Übertreten einer Sektorgrenze im Spannungsraumzeiger-Sechseck ein anderer aktiver Schaltvektor geschaltet werden müsste oder ein Nullvektor, kann bei der vorliegenden Erfindung ein Zustandsautomat mit wenigstens 14 Zuständen verwendet werden. Der Zustandsautomat kann außer den drei Bit für die Kodierung des geschalteten Schaltvektors ein zusätzliches Zyklusbit aufweisen, das angibt, ob die Raumzeigermodulation sich in der ersten oder zweiten Halbperiode des Zyklus befindet. Das Zyklusbit kodiert beim Schalten der Nullvektoren 000 und 111 keine separaten Zustände; deshalb werden nur 14 statt 16 verschiedener Zustände, die mit 4 Bit kodierbar wären, genutzt.

Durch die vorliegende Erfindung können somit im Stand der Technik auftretende, nachteilige sehr kurze Einschaltzeiten oder Ausschaltzeiten und damit verbundene hohe mittlere Schaltfrequenz auf einzelnen Phasen und daraus resultierende höhere Schaltverluste und thermische Belastung der Schalter vermieden werden.

Ein weiterer Vorteil besteht darin, dass durch die genannte Kombination von Merkmalen, insbesondere die Raumzeigermodulation, die maximale theoretisch mögliche Kleinsignal-Bandbreite in Abhängigkeit von der mittleren Schaltfrequenz erreicht werden kann.

Die Erfindung eignet sich daher für diverse Anwendungsbereiche zur Steuerung mehrphasiger elektrischer Maschinen, insbesondere elektrische Antriebe wie Drehstrommaschinen. Insbesondere eignet sich die Erfindung für alle Arten von Drehstrom-Industrie-Antrieben, von kleinen bis großen Leistungen, insbesondere solche, die ohne Multilevelkonverter angesteuert werden können. Ferner eignet sich die Erfindung für sensorlose Antriebe, d.h. Antriebe ohne Drehzahlsensor, und zwar wegen ihrer guten Spannungsregelungscharakteristik. Die Erfindung eignet sich auch für den Bereich der Elektromobilität, d.h. Elektrofahrzeuge und Hybridfahrzeuge. Durch die verbesserte Akustik und insgesamt niedrigen Schaltfrequenzen ergibt sich ein angenehmer, komfortabler Betrieb von Elektromotoren bei niedrigen Verlusten. Wegen der hervorragenden Spannungs-Abbildung der Erfindung kann eine sehr gute Regelqualität bei guter Spannungsausnutzung erreicht werden. Die Erfindung eignet sich auch für Stromrichter sonstiger Art zur Energieversorgung, z.B. zum Anschluss eines Gleichstromnetzes an ein dreiphasiges Wechselstromnetz.

Gemäß einer vorteilhaften Weiterbildung der Erfindung ist die Steuereinrichtung dazu eingerichtet, die als Eingangssignal zugeführten Bitströme digital mit von zurückgeführten Ausgangssignalen der Steuereinrichtung abgeleiteten Bitströmen zu verarbeiten, wobei jedem als Eingangssignal zugeführten Bitstrom ein von einem zurückgeführten Ausgangssignal der Steuereinrichtung abgeleiteter Bitstrom des jeweiligen Leistungsausgangs zugeordnet ist. Die Bitströme, die von einem zurückgeführten Ausgangssignal der Steuereinrichtung abgeleitet werden, können z.B. direkt von internen Schaltbits der Steuereinrichtung, wie z.B. den Bits des Zustandsautomaten, wieder zurückgeführt werden auf eine Eingangsschaltung, die diese zurückgeführten Bitströme digital mit dem als Eingangssignal zugeführten Bitströmen verarbeitet. Eine Verarbeitung auf analoger Ebene ist damit nicht erforderlich. Es erfolgt eine durchgehende digitale Verarbeitung, so dass Ungenauigkeiten oder Verluste durch Analog-/Digitalwandlungen oder umgekehrt vermieden werden.

Gemäß der Erfindung weist die Raumzeigermodulation eine Winkelhysterese, ggf. auch eine Betragshysterese, des Spannungsraumzeigers auf. Durch jede dieser Maßnahmen und insbesondere eine Kombination dieser Maßnahmen kann die Regelungsqualität weiter verbessert werden. Die Winkelhysterese erlaubt eine Aufteilung der Ebene des Spannungsraumzeigers in einander überlappende Sektoren, z.B. Sektoren mit jeweils 120° Öffnungswinkel. Zur Realisierung der Winkelhysterese wird ein zusätzliches Bit, das erwähnte Zyklusbit, ergänzt, das die jeweilige Laufrichtung innerhalb des Sektors anzeigt. Durch die Betragshysterese und die Winkelhysterese kann die Schaltfrequenz der Halbleiterschalter auf zulässige bzw. spezifikationsgemäße Werte begrenzt werden und eine unzulässig hohe Schalthäufigkeit vermieden werden, die die Halbleiterschalter sogar thermisch zerstören könnte.

Gemäß einer vorteilhaften Weiterbildung der Erfindung weist die Steuereinrichtung eine Schalttabelle auf, in der die Ebene des Spannungsraumzeigers in mindestens 12 Gebiete aufgeteilt ist. Hierdurch können Störungen der Modulation durch Totzeiteffekte minimiert werden. Weitere Verbesserungen ergeben sich, wenn die Schalttabelle dahingehend erweitert wird, dass die Ebene des Spannungsraumzeigers in wenigstens 24 Gebiete aufgeteilt ist. Mittels der Schalttabelle können die Ansteuersignale für die Halbleiterschalter direkt erzeugt werden.

Gemäß einer vorteilhaften Weiterbildung der Erfindung weist die Raumzeigermodulation einen oder mehrere Grenzwerte auf, wobei die Steuereinrichtung einen Vergleich aufweist, der zum Vergleichen des Betrags des Spannungsraumzeigers mit dem Grenzwert oder den Grenzwerten und zum Auslösen einer Schaltfunktion in dem Falle eingerichtet ist, dass der Betrag des Spannungsraumzeigers einen solchen Grenzwert überschreitet. Als Überschreitung des Grenzwerts wird dabei insbesondere eine Überschreitung von einem kleinen Betragswert hin zu einem großen Betragswert oder umgekehrt von einem großen Betragswert zu einem kleinen Betragswert angesehen, wobei jeweils der Grenzwert passiert wird. Dies erlaubt eine zusätzliche Verbesserung der Qualität der Modulation der an den Leistungsausgängen abgegebenen Signale.

Gemäß einer vorteilhaften Weiterbildung der Erfindung ist die Steuereinrichtung zur variablen Änderung des Grenzwerts oder der Grenzwerte in Abhängigkeit von dem jeweiligen als Eingangssignal zugeführten Sollwertsignal und/oder dem Betrag des Spannungsraumzeigers eingerichtet. Dies erlaubt diverse weitere Verbesserungen der Regelcharakteristik. So kann insbesondere bei kleinem Sollwertsignal der Grenzwert oder die Grenzwerte reduziert werden, um ein gleichbleibendes Reglerverhalten zu gewährleisten. Bei einem entsprechenden Anstieg des Sollwertsignals können der oder die Grenzwerte nachgeführt werden, d.h. vergrößert werden. Zudem kann über die Grenzwerte eine Regelung der mittleren Schaltfrequenz der über die Leistungsausgänge abgegebenen PWM-Signale durchgeführt werden.

Gemäß einer vorteilhaften Weiterbildung der Erfindung ist die Steuereinrichtung dazu eingerichtet, bei Überschreitung des höchsten Grenzwerts ein Rücksetzsignal zur gezielten Reduzierung von in Digitalakkumulatoren der Steuereinrichtung gespeicherten Werten durchzuführen. Dies hat den Vorteil, dass der Stromrichter auch mit guter Regelcharakteristik bei Übermodulation bzw. Übersteuerung betrieben werden kann, d.h. als Eingangssignal zugeführten Sollwertsignalen, die sich aufgrund der gegebenen Parameter nicht umsetzen lassen. Insbesondere kann ein weicher Übergang in den Bereich der Übermodulation oder Übersteuerung realisiert werden. Durch das Reduzieren der Werte, z.B. durch Löschen von Bits, können die in den Digitalakkumulatoren aufsummierten Werte bzw. deren Gradient begrenzt werden.

Der höchste Grenzwert erlaubt insbesondere einen weichen Übergang durch gezieltes Reduzieren der Werte. Hierdurch ist dann keine besondere Reserve für die Stromregelung vorzuhalten, so dass der gesamte Signalbereich ausgenutzt werden kann.

Gemäß einer vorteilhaften Weiterbildung der Erfindung ist die Steuereinrichtung dazu eingerichtet, die als Eingangssignal zugeführten Bitströme digital mit von zurückgeführten Ausgangssignalen der Steuereinrichtung abgeleiteten Bitströmen zu verarbeiten, wobei jedem als Eingangssignal zugeführten Bitstrom ein von einem zurückgeführten Ausgangssignal der Steuereinrichtung abgeleiteter Bitstrom des jeweiligen Leistungsausgangs zugeordnet ist, wobei der Stromrichter Delta-Sigma-Modulatoren zur Erzeugung der von zurückgeführten Ausgangssignalen der Steuereinrichtung abgeleiteten Bitströme, wobei die Bitstromerzeugungsmittel zur Umwandlung der an den Leistungsausgängen abgegebenen analogen Spannungen und/oder Ströme in ein Bit breite Bitströme eingerichtet ist. Dies hat den Vorteil, dass sämtliche Einflüsse, die sich durch die verwendete Hardware und insbesondere deren veränderliche Parameter, wie Totzeiteffekte, Temperatureinfluss und Kennlinien, durch Rückführung der aus den tatsächlich an der elektrischen Maschine oder sonstigen Last anliegenden Signalen komplett ausgeschlossen werden können. Es können insbesondere die eingangs genannten Nachteile, die bisher durch die Vorwärtsaufschaltung kompensiert werden sollten, in erheblich verbesserter Weise überwunden werden. Insbesondere sind sämtliche Stromrichter-Nichtlinearitäten damit ausgeschlossen. Die Bitstromerzeugungsmittel sind als Delta-Sigma-Modulatoren ausgebildet, die das analoge Ausgangssignal der Steuereinrichtung, z.B. die dort abgegebene analoge Spannung oder den in der jeweiligen Phase zur elektrischen Maschine oder sonstigen Last fließenden Strom, in jeweils einen ein Bit breiten Bitstrom digitalisieren.

Insbesondere ist hierfür keine Motornachbildung oder ein sonstiges Netzwerk erforderlich. Es können direkt die an der elektrischen Maschine oder sonstigen Last anliegenden elektrischen Daten erfasst werden.

Ein weiterer Vorteil ist, dass bei Erfassung der analogen Ströme und deren Rücckopplung in Form von Bitströmen der Stromrichter auch zur Stromregelung der über die Leistungsausgänge abgegebenen Ströme eingerichtet sein kann. Auf diese Weise ist bei unverändertem Konzept des Stromrichters zugleich eine Stromregelung möglich. Diese ist in vielen Anwendungsfällen elektrischer Maschinen und Netz-Stromrichter erforderlich. Vorteilhafterweise benötigt der erfindungsgemäße Stromrichter hierzu im Wesentlichen keine zusätzlichen Bauteile, außer den jeweiligen Analog-Erfassungsmitteln zur Messung der analogen Ströme, die bei einer Stromregelung ohnehin erforderlich sind. Bei der Stromregelung können als Eingangssignale und damit als Sollwertsignale insbesondere Bitströme zugeführt werden, deren Mittelwert einen Sollstrom angibt.

Insbesondere kann die Stromregelung kombiniert mit der Rückkopplung von Bitströmen, die Spannungssignale repräsentieren, durchgeführt werden. Auf diese Weise kann eine Spannungsregelung mit überlagerter Stromregelung realisiert werden. Mittels der Spannungsregelung kann dabei der Regler stabil gehalten werden. Über die Spannungsregelung dominiert dann die Stromregelung, z.B. indem ein Regler mit großer Verstärkung verwendet wird, wie z.B. ein P-Regler.

Gemäß einer vorteilhaften Weiterbildung der Erfindung weist die Steuereinrichtung eine Regeleinheit auf, die dazu eingerichtet ist, die mittlere Schaltfrequenz der Ausgangssignale der Leistungsausgänge zu bestimmen und eine Regelung der mittleren Schaltfrequenz auf einen vorgegebenen Sollwert durchzuführen. Auf diese Weise kann der hinsichtlich der Schaltfrequenz an sich freilaufende Stromrichter derart verbessert werden, dass die Schaltfrequenz stabilisiert wird und zumindest in einer bestimmten Bandbreite um den Sollwert gehalten wird. Die Regelung der mittleren Schaltfrequenz kann z.B. durch Anpassung der zuvor bereits erläuterten Grenzwerte des Spannungsraumzeigers durchgeführt werden. Soll die mittlere Schaltfrequenz erhöht werden, werden die Grenzwerte tendenziell abgesenkt; soll die mittlere Schaltfrequenz verringert werden, werden die Grenzwerte tendenziell angehoben.

Gemäß einer vorteilhaften Weiterbildung der Erfindung weist die Steuereinrichtung eingangsseitig einen Quantendekoder in Kombination mit einer Inkrementabelle auf, die dazu eingerichtet ist, die als Eingangssignal zugeführten Bitströme in Quanten zu dekodieren (gemäß Dissertation von Nitish Patel, "Bit-Streams - Applications in Control", Mai 2006, The University of Auckland, New Zealand) und vorzeichenrichtig zu Inkrementen zu summieren. So kann z.B. in einem Schritt jeder Bitstrom in ternäre Quanten mit den Werten +1, 0, -1 dekodiert werden und zusammen mit den ternären Quanten der von einem zurückgeführten Ausgangssignal der Steuereinrichtung abgeleiteten Bitströme in einer Inkrementtabelle zu den Inkrementen für die Digitalakkumulatoren zusammen addiert werden. (bei zweikanaliger Ausbildung der Steuereinrichtung, d.h. für zwei Digitalakkumulatoren).

Gemäß einer vorteilhaften Weiterbildung der Erfindung weist die Steuereinrichtung wenigstens zwei Digitalakkumulatoren auf, die der Inkrementabelle nachgeschaltet sind, wobei die Digitalakkumulatoren dazu eingerichtet sind, die von der Inkrementabelle abgegebenen Inkremente aufzusummieren. Die Digitalakkumulatoren sind damit ähnlich wie Zähler ausgebildet. Die Digitalakkumulatoren können z.B. mehrere Bit Wortbreite aufweisen, z.B. sechs, acht oder zehn bis zwanzig Bit. Die Wortbreite sollte nicht zu klein gewählt werden, um zu hohe Schaltfrequenzen zu vermeiden.

Gemäß einer vorteilhaften Weiterbildung der Erfindung ist die Inkrementabelle dazu eingerichtet, die Quanten von zugeführten Bitströmen, die Stromsignale repräsentieren, anders zu gewichten als die Quanten von zugeführten Bitströmen, die Spannungssignale repräsentieren, um eine Reglerverstärkung zu erzielen. Auch hierdurch kann die Qualität der Regelung weiter verbessert werden, insbesondere wenn eine Stromregelung erforderlich ist.

Die in den Digitalakkumulatoren vorliegenden Digitalworte können einer nachgeschalteten Schalttabelle zugeführt sein, die Teil der Steuereinrichtung ist. Die Schalttabelle kann ausgangsseitig die Ein- und Ausschaltsignale für die Halbleiterschalter ausgeben, wobei der Schalttabelle zur Realisierung eines Schaltwerks Flipflops oder andere Speicherbausteine nachgeschaltet sind. Bei einer z.B. dreiphasigen Ausführung des Stromrichters sind dann drei Flipflops für die jeweiligen Phasen sowie bei Anwendung der Zyklussteuerung ein zusätzliches Flipflop für das Zyklusbit erforderlich. Auf diese Weise ergibt sich bei einer dreiphasigen Ausführung eine Vierbit-Speicherung durch die Flipflops. Allgemein gesagt sind n +1 Bits oder Flipflops erforderlich, wenn n die Zahl der Phasen des mehrphasigen Stromrichters ist.

Die eingangs genannte Aufgabe wird außerdem durch ein Computerprogramm gemäß Anspruch 14 gelöst. Das Computerprogramm weist Programmcodemittel auf, eingerichtet zur Durchführung des folgenden Verfahrens, wenn das Computerprogramm auf einem Rechner des Stromrichters ausgeführt wird:
- Verarbeiten eines dem Stromrichter als Eingangssignal zugeführten Sollwertsignals in Form jeweils eines ein Bit oder mehrere Bits breiten Bitstroms für jede Phase,
- Erzeugen von Betätigungssignalen der Halbleiterschalter in Abhängigkeit von den als Eingangssignal zugeführten Bitströmen mittels Raumzeigermodulation.

Die Erfindung kann damit vollständig softwaremäßig mit festgelegter Hardware, vollständig hardwaremäßig oder teilweise in Software und teilweise in Hardware implementiert umgesetzt werden. Als der zuvor genannte Rechner kann z.B. ein schneller Mikroprozessor oder ein Mikrocontroller verwendet werden, ein digitaler Signalprozessor, ein FPGA oder ein sonstiges Gatearray oder eine vergleichbare elektronische Schaltung.

Die zuvor erläuterten Ausführungsformen der Erfindung beinhalten insbesondere die Erzeugung der Betätigungssignale der Halbleiterschalter mittels der Raumzeigermodulation. Die Raumzeigermodulation ist eine vorteilhafte Modulationsart insbesondere für dreiphasige Systeme, d.h. dreiphasige Stromrichter und dreiphasig mittels des Stromrichters betriebene Lasten. Die vorteilhaften Wirkungen und Effekte der Erfindung lassen sich allerdings auch bei Stromrichtern mit weniger Phasen realisieren, z.B. bei Ansteuerung einer zweipoligen Last, die mittels des Stromrichters bipolar angesteuert werden kann. Mit anderen Worten, jeder Anschluss der zweipoligen Last kann über den Stromrichter zwischen einer oberen und einer unteren Zwischenkreisspannung umgeschaltet werden. Hierdurch können insbesondere Elektromotoren in beiden Drehrichtungen betrieben werden, d.h. umgepolt werden. Für die Ansteuerung solcher Lasten kann der Stromrichter z.B. ein Leistungsteil aufweisen, das zwei Halbbrückenschaltungen von Halbleiterschaltern aufweist, zwischen denen im Sinne einer Brückenschaltung die Last angeschlossen ist. Eine solche Schaltungsanordnung wird auch als H-Brückenschaltung oder kurz H-Brücke bezeichnet.

Gemeinsames Charakteristikum der zuvor beschriebenen mehrphasigen Stromrichter, z.B. von dreiphasigen Stromrichtern, und der H-Brückenschaltung ist, dass für die Erzeugung des gewünschten Wechselstromsignals an einem Anschluss der Last mehrere Schaltmöglichkeiten der Halbleiterschalter vorhanden sind, um das gewünschte Signal zu erzeugen. So kann z.B. bei einer H-Brücke ein Wechselstrom erzeugt werden, in dem immer nur der obere Halbleiterschalter der einen Halbbrücke ein- und ausgeschaltet wird und der untere Halbleiterschalter der anderen Halbbrücke permanent eingeschaltet bleibt. Umgekehrt kann auch der obere Halbleiterschalter der einen Halbbrücke permanent eingeschaltet sein, und nur der untere Halbleiterschalter der anderen Halbbrücke ein- und ausgeschaltet werden. In beiden Fällen wird an der Last das gleiche Wechselspannungssignal erzeugt. Nachteilig ist hierbei die ungleiche Beanspruchung der Halbleiterschalter, die insbesondere beim Umschalten in Folge der Schaltverluste auftritt. Infolgedessen kommt es zu unterschiedlichen Erwärmungen der Halbleiterschalter, so dass unterschiedliche Kühlmaßnahmen erforderlich sind. Dem kann durch die Erfindung entgegengewirkt werden. Durch die vorteilhafte, intelligente Steuerung der Halbleiterschalter mittels der Steuereinrichtung und die dadurch erzeugten Schaltsequenzen können die erläuterten Nachteile vermieden werden. Gemäß einer Ausführungsform der Erfindung ist daher die Steuereinrichtung, z.B. durch deren das Schaltwerk, dazu eingerichtet, Schaltsequenzen der Betätigungssignale der Halbleiterschalter zu erzeugen, durch die die Belastung der Halbleiterschalter im zeitlichen Mittel gleichmäßig auf die Halbleiterschalter verteilt ist. So können z.B. bei der Ausführungsform mit der H-Brücke in Folge der vorteilhaften Ausgestaltung der Steuereinrichtung die oberen und unteren Halbleiterschalter im zeitlichen Mittel gleichmäßig oft umgeschaltet werden, unabhängig davon, welche Betriebsweise die angeschlossene Last haben soll, z.B. ob ein permanenter Betrieb eines Elektromotors in nur einer Drehrichtung erforderlich ist, oder ein häufiger Wechsel der Drehrichtung.

Die Erfindung eignet sich hierdurch insbesondere zur Ansteuerung von Elektromotoren, z.B. in Form von Schrittmotoren.

Gemäß einer vorteilhaften Weiterbildung der Erfindung weist das Schaltwerk zusätzlich zu Zustandsbits, die den Ausgangs-Schaltsignalen damit den Betätigungssignalen der Halbleiterschalter entsprechen, wenigstens ein zusätzliches Bit in Form eines Zyklusbits auf, durch das die gleichmäßige Verteilung der Belastung der Halbleiterschalter gesteuert ist. Durch das Zyklusbit kann somit ein "Merker" gesetzt werden, wie die Halbleiterschalter in der Vergangenheit betätigt wurden, so dass durch Auswertung des Zyklusbits eine entsprechende Vergleichmäßigung des Schaltens der Halbleiterschalter in der Zukunft erreicht werden kann. Vorteilhafterweise kann diese Vergleichmäßigung der Belastung der Halbleiterschalter bereits mit einem minimalen Speicherungsaufwand in Form eines einzigen Bits, nämlich des Zyklusbits, erreicht werden. Es muss nicht die gesamte Betätigungsgeschichte in Form vieler Speicherworte oder Speicherbits für jeden Halbleiterschalter gespeichert werden. Bereits mit einem Zyklusbit kann eine solche Funktionalität erreicht werden.

Die zuvor bezüglich der Ausführungsform der Erfindung mit der Raumzeigermodulation beschriebenen Vorteile lassen sich auch bei der soeben beschriebenen Ausführungsform realisieren. Umgekehrt gelten die nachfolgend beschriebenen Vorteile auch für die Ausführungsform mit der Raumzeigermodulation.

Die Erfindung eignet sich insbesondere für Kleinantriebe mit Gleichstrommotoren und Schrittmotoren. Als Sollwertsignal dienen ein oder mehrere Bit breite Bitströme. Vorteilhaft sind insbesondere ein Bit breite Bitströme, die z.B. durch Delta-Sigma-Modulation erzeugt werden können. Hierbei entspricht der Mittelwert der Bits des Bitstroms dem gewünschten Spannungswert, der am Leistungsausgang des Stromrichters erzeugt werden soll. Mit der Erfindung können gezielt Freilaufzustände des Stromrichters, z.B. beide Halbbrücken auf der positiven oder beide Halbbrücken auf der negativen Seite geschaltet, durch die die Spannung 0 am Leistungsausgang erzeugt wird, verwendet werden.

Die Erfindung wird nachfolgend anhand von Ausführungsbeispielen unter Verwendung von Zeichnungen näher erläutert.

Es zeigen
- Figur 1: eine erste Ausführungsform eines Stromrichters und
- Figur 2: ein Spannungsraumzeiger-Diagramm und
- Figur 3: ein weiteres Spannungsraumzeiger-Diagramm und
- Figur 4: eine zweite Ausführungsform eines Stromrichters und
- Figur 5: eine dritte Ausführungsform eines Stromrichters und
- Figur 6: eine vierte Ausführungsform eines Stromrichters und
- Figur 7: eine fünfte Ausführungsform eines Stromrichters und
- Figur 8: eine sechste Ausführungsform eines Stromrichters und
- Figur 9: den prinzipiellen Aufbau der Leistungsstufe eines Stromrichters, bei dem Halbbrückenschaltungen verwendet werden und
- Figur 10: eine siebte Ausführungsform eines Stromrichters und
- Figur 11: eine achte Ausführungsform eines Stromrichters und
- Figur 12: ein Funktionsdiagramm hinsichtlich der siebten und achten Ausführungsform des Stromrichters.

In den Figuren werden gleiche Bezugszeichen für einander entsprechende Elemente verwendet.

Als Ausführungsbeispiel wird vorgeschlagen, als Steuereinrichtung einen Modulator zur Pulsweitenmodulation eines Stromrichters zu bauen, der einen vektoriellen Spannungssollwert in Form von drei Bitstromsignalen am Eingang enthält, daraus mit rückgeführten Schaltersignalen, die entweder direkt am Ausgang des Modulators noch innerhalb der Signalelektronik abgegriffen werden, oder die von analog über Delta-Sigma-Modulatoren gemessenen Phasenspannungen gewonnen werden, einen vektoriellen integralen Fehler zu bilden. Dieser wird nach Betrag und Phase in mindestens 12 Bereiche quantisiert, besser 18 mit der Möglichkeit den Fehler bei Übersteuerung zu begrenzen, und in einer Schalttabelle bewertet. Zusammen mit vier Zustandsspeicherbits entsteht ein Schaltwerk, das gezielt Schaltsequenzen erzeugt, die bei normaler Aussteuerung Zyklen bilden, wie sie der Raumzeigermodulation entsprechen. Zyklus: (<0,0,0>,V1,V2,<1,1,1>,V2,V1,<0,0,0>) (siehe Tabelle 1). Dabei entsprechen drei der Zustandsbits direkt den Ausgangs-Schaltsignalen, das vierte Bit gibt die Laufrichtung im Zyklus <0,0,0> → <1,1,1> oder <1,1,1> → <0,0,0> an. Bei größeren Aussteuergraden wird der Zyklus verkürzt zu einem Wechsel zwischen V1 (ein Bit gesetzt) und V2 (zwei Bit gesetzt). Bei noch größeren Beträgen des Spannungssollwerts findet außerdem ein nahtloser Übergang in die Übersteuerung statt, bei der Inkremente des Fehlerspeichers Winkel-richtig gelöscht werden, um Überläufe zu verhindern und trotzdem die richtige Phase des erwünschten Ausgangsvektors zu modulieren.

**Tabelle 1:**

| Schaltvektor <P₃,P₂,P₁> | Typ |
|---|---|
| <0,0,0> | Null |
| <1,1,1> | Null |
| <0,0,1> | V1,aktiv |
| <0,1,0> | V1,aktiv |
| <1,0,0> | V1,aktiv |
| <1,0,1> | V2,aktiv |
| <0,1,1> | V2,aktiv |
| <1,1,0> | V2,aktiv |

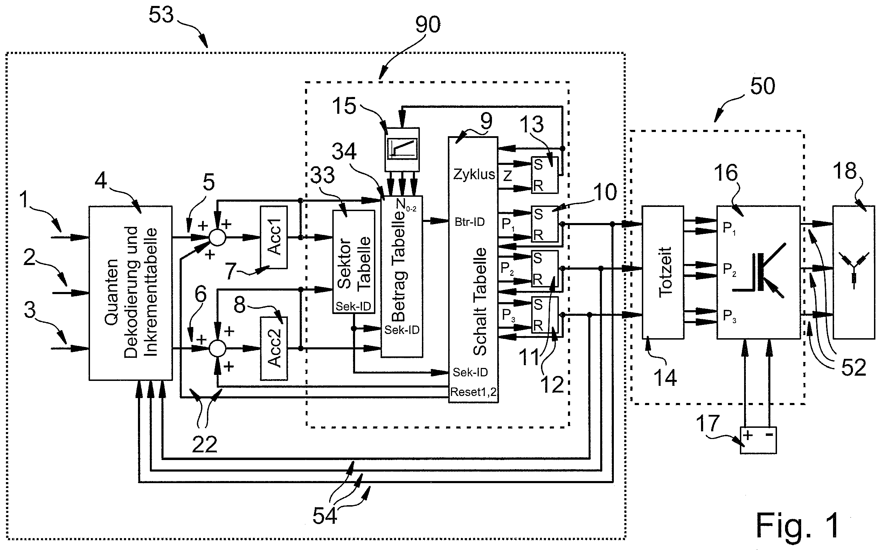

Die Figur 1 zeigt ein Schaltschema der verwendeten Signalverarbeitung für einen Modulator mit Rückführung der Schaltersignale innerhalb der Signalverarbeitung. Die Schaltung erhält am Sollwerteingang als Eingangssignal und damit als Sollwertsignal drei Delta-Sigma Bitströme 1, 2, 3 für den vektoriellen Spannungssollwert am Ausgang. Die Ausgangsbits des Schaltwerks 90 werden als zurückgeführte Bitströme 54 zusammen mit den Bitströmen 1, 2, 3 des Eingangssignals dem Quantendekoder 4 mit der Inkrementtabelle zugeführt, die eine Inkrementbildung durchführt. Der gegenüber dem Vorschlag von Patel um die Inkrementabelle erweiterte Quantendekoder 4 sei zur sprachlichen Vereinfachung nachfolgend nur als Quantendekoder bezeichnet. Darin werden die drei Bitströme 1, 2, 3 zunächst durch Vergleich mit einem Nullbitstrom (Rechtecksignalsignal, bei dem die aufeinander folgenden Bits zwischen 0 und 1 wechseln) in ternäre Quanten (+1,0,-1) dekodiert. Wie in Tabelle 2 angegeben, werden die Quanten für die nachfolgende Summation in den Digitalakkumulatoren 7, 8 gewichtet. Die Ausgangsbits des Schaltwerks 90 werden ebenso wie die Sollwerte einer Quantendekodierung unterworfen. Der Quantendekoder 4 erzeugt zwei Ausgangssignale 5, 6, wobei gemäß Tabelle 2 die Anteile von Soll- und Istwerten bereits addiert sind, mit der Breite mehrerer Bits, die in den Digitalakkumulatoren 7, 8 zusammen mit zwei Rücksetzsignalen 22 aus dem Schaltwerk 90 zu jeweils einem ganzzahligen Digitalwort mit Vorzeichen aufakkumuliert werden.

**Tabelle 2:**

| | Acc1 | Acc2 |
|---|---|---|
| Uₛₒₗₗ₁ | +1 | 0 |
| Uₛₒₗₗ₂ | 0 | +1 |
| Uₛₒₗₗ₃ | -1 | -1 |
| Uᵢₛₜ₁ | -1 | 0 |
| Uᵢₛₜ₂ | 0 | -1 |
| Uᵢₛₜ₃ | +1 | +1 |

Falls eine Übermodulation gewünscht wird, kann das Eingangssignal 1, 2, 3 im Quantendekoder 4 größere Gewichte erhalten als das Rückführsignal, d.h. die Ausgangsbits des Schaltwerks 9. Die Ausgangssignale 5, 6 des Quantendekoders 4 mit den jeweils möglichen Werten <+2,+1,0,-1,-2> (Bei höherer Gewichtung des Eingangs können abweichende Werte auftreten) werden den Digitalakkumulatoren 7, 8 zugeführt, die sie mit jedem Takt der Bitströme aufaddieren. Weiterhin werden die Rücksetzsignale 22 aus dem Schaltwerk 9, die der Begrenzung des Fehlers im Übersteuerungsfalle dienen, in den Digitalakkumulatoren 7, 8 mit aufakkumuliert. Hinter den Digitalakkumulatoren 7, 8 stehen zwei Digitalworte mit Vorzeichen in einer Wortbreite von sechs bis zwanzig Bit Breite zur Verfügung, die dem Schaltwerk 90 zugeführt werden. Dieses wiederum erzeugt die Signale zum Setzen und Löschen der drei Ausgangsbits, die in den Flipflops 10, 11, 12 gespeichert sind, und für ein weiteres Zyklusbit gemäß Flipflop 13, das den Halbzyklus der Schaltperiode der Raumzeigermodulation kodiert.

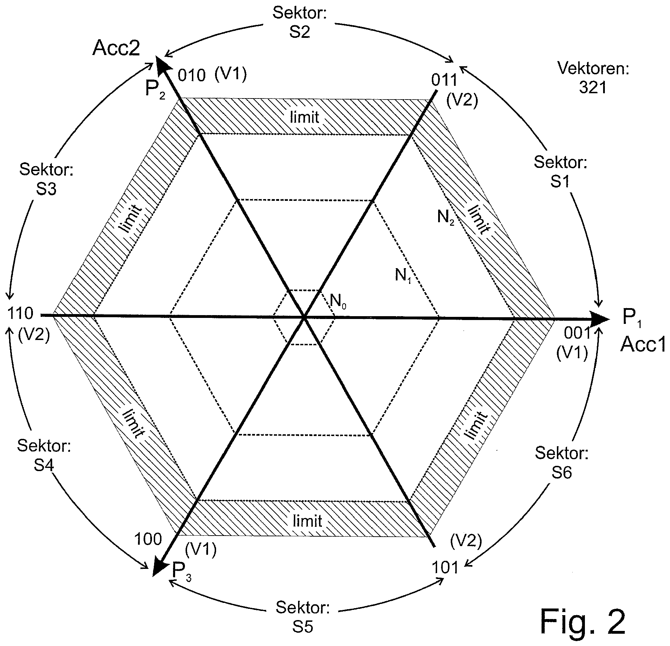

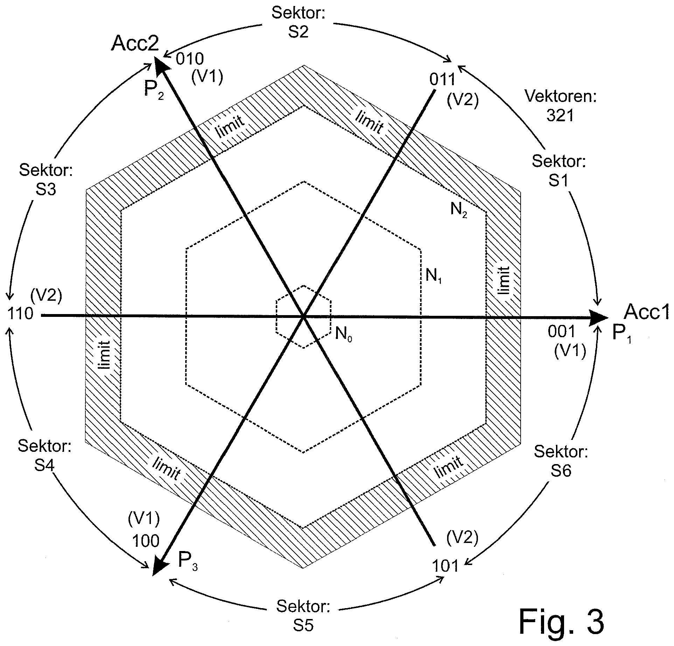

Gemäß Figur 2 und 3 erfolgt die vektorielle Quantisierung des Fehlers, der in den beiden Digitalakkumulatoren 7, 8 aufsummiert wird, in mindestens 12 Bereiche: Sechs Sektoren S1 bis S6, die durch einen Grenzwert N₁ für den Betrag des Spannungsraumzeigers jeweils geteilt werden und somit 12 Bereiche ergeben. Eine weiter verbesserte Unterdrückung von Störungen der Modulation durch Totzeiteffekte ergibt sich, wenn für kleine Beträge des Spannungsraumzeigers noch der Bereich in der Nähe des Zentrums differenziert ausgewertet wird, z.B. indem ein weiterer Grenzwert No ergänzt wird. Im Falle einer Übersteuerung des Modulators kann zur Begrenzung noch eine betragsmäßige Unterscheidung entsprechend einem oberen (höchsten) Grenzwert N₂ ergänzt werden. So entsteht eine Quantisierung in 24 Bereiche, nämlich 6 Sektoren, die durch drei Grenzwerte jeweils in vier Bereiche geteilt sind.

Die Betragsbildung des Spannungsraumzeigers kann z.B. gemäß Figur 2 (Sechseck, dessen Ecken in Richtung der Vektoren V1 und V2 zeigen) oder Figur 3 (Sechseck, das gegenüber Figur 2 um 30° gekippt ist) erfolgen.

Das Schaltwerk 90 bildet ein zentrales Element der Steuereinrichtung 53, dass das Verhalten des Modulators entsprechend der Raumzeigermodulation bestimmt. Das Verhalten des Schaltwerks 90 wird nachfolgend anhand Figur 2 erklärt, die den in den Digitalakkumulatoren 7, 8, entsprechend Acc1 und Acc2, akkumulierten Spannungsfehler in einem 120° Koordinatensystem zeigt.

In dem Schaltwerk wird anhand der Sektortabelle 33 zunächst die Sektornummer anhand des Fehlervektors mit den beiden Komponenten, die aus den Inhalten der Digitalakkumulatoren 7, 8 in einem Koordinatensystem, dessen Achsen einen Winkel von 120 ° zueinander bilden, bestimmt, wie in Tabelle 3 dargestellt.

**Tabelle 3:**

| Acc1<=0 | Acc2 >= 0 | Acc2-Acc1>=0 | Sektor |
|---|---|---|---|
| X | 1 | 0 | S1 |
| 0 | X | 1 | S2 |
| 1 | 1 | X | S3 |
| X | 0 | 1 | S4 |
| 1 | X | 0 | S5 |
| 0 | 0 | X | S6 |

Nach der Ermittlung des Sektors (S1...S6) wird anhand der Betragstabelle 34 der Betrag des Fehlervektors ermittelt und danach unterschieden, ob er kleiner als No, zwischen No und N₁, zwischen N₁ und N₂ oder oberhalb von N₂ liegt. Dies kann beispielsweise anhand der folgenden Tabelle mit einer Betragsidentifikation, auch Betrags-ID oder BTR-ID genannt, kodiert werden.

| Sektor | Betragsbedingung | Betrags-ID |
|---|---|---|
| S1 | Acc1<N₀ | 0 |
| S1 | N₀<Acc1<N₁ | 1 |
| S1 | N₁<Acc1<N₂ | 2 |
| S1 | Acc1>N₂ | 3 |
| S2 | Acc2<N₀ | 0 |
| S2 | N₀<Acc2<N₁ | 1 |
| S2 | N₁<Acc2<N₂ | 2 |
| S2 | Acc2>N₂ | 3 |
| S3 | Acc1-Acc2>N₀ | 0 |
| S3 | N₀>Acc1-Acc2>N₁ | 1 |
| S3 | N₁>Acc1-Acc2>N₂ | 2 |
| S3 | Acc1-Acc2<N₂ | 3 |
| S4 | Acc1>-N₀ | 0 |
| S4 | -N₀>Acc1>-N₁ | 1 |
| S4 | -N₁>Acc1>-N₂ | 2 |
| S4 | Acc1<-N₂ | 3 |
| S5 | Acc2>-N₀ | 0 |
| S5 | -N₀>Acc2>-N₁ | 1 |
| S5 | -N₁>Acc2>-N₂ | 2 |
| S5 | Acc2<-N₂ | 3 |
| S6 | Acc2-Acc1>-N₀ | 0 |
| S6 | -N₀>Acc2-Acc1 >-N₁ | 1 |
| S6 | -N₁>Acc2-Acc1 >-N₂ | 2 |
| S6 | Acc2-Acc1 <-N₂ | 3 |

In das Schaltwerk geht weiterhin der augenblicklich geschaltete Ausgangsvektor in den Zustandsbits 10, 11, 12 und das Zyklusbit 13 ein. Abhängig von den gerade anliegenden Sollwertsignalen gemäß den Bitströmen 1, 2, 3 und dem gerade geschalteten Spannungsvektor am Ausgang des Modulators beschreibt der Fehlervektor in Acc1, Acc2 von Takt zu Takt des Bitstromsignals eine Bahn durch die Bereiche des Sechsecks in Figur 2 bzw. 3. Damit kann das Entstehen eines Schaltzyklus wie folgt erklärt werden.

Nimmt man an, dass zu Beginn der Betrachtung alle vier Ausgangsbits <P₃,P_{2,},P₁,Z>, d.h. die Zustandsbits 10, 11, 12 und das Zyklusbit 13, Null sind und dass der Spannungsfehler <Acc1,Acc2> ebenfalls Null ist, so befindet sich der Fehlerzustand genau in der Mitte des Koordinatensystems. Wird jetzt ein Sollwertsignal gemäß den Bitströmen 1, 2, 3 als Mittelwert vorgegeben, so laufen die Sollwert-Quanten vom Quantendekoder 4 in die Digitalakkumulatoren 7, 8 ein, ohne dass aus den Istwertsignalen, die von den Zustandsbits 10, 11, 12 stammen, Quanten geliefert werden, weil als Spannungsvektor gerade ein Nullvektor geschaltet ist. Damit bewegt sich mit jedem Takt der Sollwertsignale der Fehlervektor aus der Mitte heraus und sein Betrag überschreitet irgendwann den Grenzwert N₁. Hier wird dann ein aktiver Schaltvektor geschaltet.

Die Schaltvektoren, die von den 3 Halbbrücken des Leistungsteils 16 geschaltet werden, lassen sich in drei Typen gemäß Tabelle 1 einteilen: Sind alle drei Schalter zur positiven Schiene der Zwischenkreisspannung geschaltet <1,1,1> oder alle drei Schalter zur negativen Seite <0,0,0>, so liegt keine Differenzspannung an den Ausgangsklemmen an. Diese Schaltvektoren werden als Nullvektor bezeichnet. Dann gibt es noch Schaltvektoren, bei denen nur ein Schalter zur positiven Seite geschaltet ist; diesen wird der Typ V1 zugeordnet, entsprechend bei zwei Schaltern zur positiven Seite der Typ V2. V1 und V2 werden auch als aktive Schaltvektoren bezeichnet, weil die anliegende Spannung an der Last von Null verschieden ist.

Die Auslegung des Schaltwerks erfolgt so, dass die Schaltzyklen der Raumzeigermodulation entsprechen. Dabei entsteht ein Zyklus, bei dem ausgehend vom Nullvektor <0,0,0> ein Schaltvektor V1, dann ein Schaltvektor V2, der Nullvektor <1,1,1>, und zurück V2, V1 und der Nullvektor <0,0,0> geschaltet werden. Dieser Zyklus ist der Normalzyklus, der sich ergibt, wenn der Betrag des Spannungssollwerts in allen Winkellagen ohne Übersteuerung des Leistungsteils moduliert werden kann. Abhängig vom Betrag des geforderten Spannungsraumzeigers ergeben sich weitere mögliche Zyklen, bei denen nur zwischen zwei aktiven Schaltvektoren geschaltet wird.

Der Normalzyklus der Raumzeigermodulation entsteht, wenn der Fehlervektor in <Acc1,Acc2> sich ausgehend vom Zustand <P₃,P_{2,},P₁,Z> = <0,0,0,0> und <Acc1,Acc2> = <0,0> über die Grenze N₁ bewegt. Dann wird der Sektor ermittelt, in dem sich der Fehlervektor <Acc1,Acc2> befindet. Dieser Sektor wird von einem Schaltvektor Typ V1 und auf der anderen Seite von einem Schaltvektor Typ V2 begrenzt (Figur 2 oder 3). Da das Zyklusbit 13 Null ist, wird der Schaltvektor V1 geschaltet und die Bits 10, 11, 12 <P₃,P_{2,},P₁> entsprechend gesetzt. Dieser Zustand bleibt solange bestehen bis der Fehlervektor <Acc1,Acc2> in irgendeine Richtung den Bereich der beiden Sektoren verlässt, die neben dem aktuell ausgegebenen Schaltvektor V1 liegen. Wird diese Sektorgrenze überschritten, so wird der Schaltvektor V2 geschaltet, der den neu betretenen Sektor auf einer der Seiten begrenzt. Ist außerdem der Betrag des Fehlervektors außerhalb von N₁, so wird zusätzlich das Zyklusbit 13 gesetzt. Der weitere Ablauf entspricht dann der zweiten Hälfte des Schaltzyklus. Hingegen bleibt bei einem Betrag innerhalb von N₁ das Zyklusbit auf Null und der geschaltete Schaltvektor V2 solange geschaltet, bis der Fehlervektor den Bereich der beiden Sektoren verlässt, die neben dem aktuell ausgegebenen Schaltvektor V2 liegen. Ist dann der Fehlervektor immer noch innerhalb von N₁, und das Zyklusbit Null, so wird der Nullvektor <1,1,1> geschaltet und das Zyklusbit 13 gesetzt. Wird der Betrag kleiner als N₀, während der Schaltvektor V2 geschaltet ist, so wird sofort der Nullvektor <1,1,1> geschaltet und das Zyklusbit 13 gesetzt. Nun ist der Fehlervektor mit zwei Zügen etwa in Richtung des Zentrums des Sechsecks gelaufen, weil die aktiven Schaltvektoren im Normalbetrieb einen größeren Betrag aufweisen als der Sollwert. Nach dem Schalten des Nullvektors führt der Sollwert gemäß den Bitströmen 1, 2, 3 mit einem Betrag größer als Null dazu, dass der Fehlervektor wieder nach außen läuft. Bei neuerlichem betragsmäßigen Überschreiten des Grenzwerts N₁ und gesetztem Zyklusbit wird jetzt der Schaltvektor V2 geschaltet, der den aktuellen Sektor an einer Seite begrenzt. Dieser bleibt solange geschaltet, bis der Bereich verlassen wird, der von den beiden Sektoren gebildet wird, die neben dem aktuell geschalteten Schaltvektor V2 liegen. Da jetzt das Zyklusbit gesetzt ist, wird als nächstes der Schaltvektor V1 geschaltet, der den aktuell betretenen Sektor an einer Seite begrenzt. Ist dabei der Betrag des Fehlervektors größer als N₁, so wird zusätzlich das Zyklusbit gelöscht. Ansonsten bleibt der Schaltvektor V1 so lange geschaltet, bis wiederum der diesem Schaltvektor zugeordnete 120° Bereich verlassen wird. Dann wird der Nullvektor <0,0,0> geschaltet und das Zyklusbit gelöscht und der Zyklus beginnt ganz von vorne.

Die eben erläuterten Sequenzen
<0,0,0,0> => V1 => V2 => <1,1,1,1> => V2 => V1 => <0,0,0,0> oder
<V1, Z=0> => <V2, Z=1> => <V1, Z=0> usw.
laufen nur ab, wenn der Sollwert gemäß den Bitströmen 1, 2, 3 keine Übermodulation erzwingt. Sind die Sollwerte betragsmäßig größer, so führt das dazu, dass die von den Zustandsbits 10, 11, 12 <P₃,P_{2,},P₁> oder den Spannungs-Istwerten an den Quantendekoder zurückgeführten Quanten nicht ausreichen, um den Fehlervektor in <Acc1,Acc2> wieder zum Zentrum des Sechsecks zurückzuführen. Der Fehlerbetrag würde über alle Grenzwerte wachsen und irgendwann zu Überläufen und damit einer Fehlfunktion des Modulators führen. Daher greift mit der Betragsgrenze N₂ eine Begrenzungsfunktion in dem Schaltwerk. Überschreitet der Fehlervektor betragsmäßig den Grenzwert N₂, wird auf den Rücksetzsignalen 22 ein Paar von Integerzahlen ausgegeben, die den Fehlervektor parallel zum aktuell geschalteten Schaltvektor wieder in den Betragsbereich zwischen N₁ und N₂ zurückführt. Damit werden nur solche Quanten gelöscht, die in Richtung des aktuell geschalteten Schaltvektors liegen. Dazu quer liegende Quanten werden weiter akkumuliert und sorgen dafür, dass letztlich eine Modulation zwischen einem V1,V2-Paar entsteht, die im Mittel zumindest den Winkel des Sollvektors am Ausgang richtig wiedergibt.

Die weiteren Teile des Schemas in Figur 1 dienen der Erläuterung der Integration der Steuereinrichtung in einen Stromrichter. Die Schaltersignale <P₃,P_{2,},P₁>, die aus den Zustandsbits 10, 11, 12, erzeugt werden, werden in einem Schaltblock 14 mit Totzeiten versehen und an das Leistungsteil 16 als Schalteransteuersignale übergeben. Das Leistungsteil 16 wird von einer Gleichspannungsquelle 17 gespeist und versorgt die dreiphasige Last 18.

Eine Regeleinrichtung 15 misst die Schaltfrequenz auf dem Zyklusbit 13 und führt die drei Grenzwerte N₀, N₁, N₂ der Betragstabelle 34 in gleichen Verhältnissen nach, so dass eine gewünschte mittlere Schaltfrequenz ausgeregelt wird. Kleinere Werte der Grenzwerte N₀, N₁, N₂ erhöhen die Schaltfrequenz, weil weniger Takte benötigt werden, um ein Schaltereignis auszulösen. Die drei Zustandsbits 10, 11, 12 <P₃,P_{2,},P₁> werden zusammen mit dem Zyklusbit 13 in das Schaltwerk als Zustand zurückgeführt.

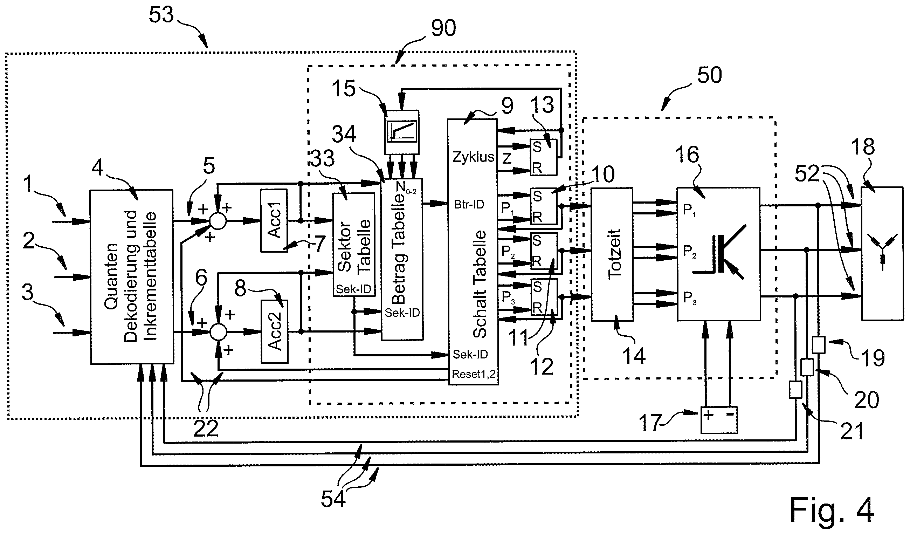

Die Figur 4 zeigt ein Schaltschema eines Modulators für ein dreiphasiges Leistungsteil mit entsprechender Last, hier aber mit einer Rückführung der gemessenen analogen Spannungen anstelle der internen Zustandsbits 10, 11, 12. Die analogen Spannungen werden über analoge Delta-Sigma Modulatoren 19, 20, 21 digitalisiert und als Bitströme 54 ausgegeben. Diese Bitströme laufen jetzt anstelle der Zustandsbits in den Quantendekoder und werden gemäß Tabelle 2 verarbeitet. Die Skalierung der Bitströme 1, 2, 3 am Eingang wird nun durch die Skalierung der Eingangsspannungsbereiche der Delta-Sigma Modulatoren 19, 20, 21 bestimmt. Gemessen werden direkt die geschalteten Ausgangsspannungen als Phasenpotenziale, z.B. gegenüber der Zwischenkreisspannungsschiene oder gegenüber dem Erdpotential oder irgendeinem anderen geeigneten gemeinsamen Potential, in analoger Form über die Delta-Sigma Modulatoren 19, 20, 21 ohne weitere zwischengeschaltete Filter. Dies hat den Vorteil, dass alle auftretenden Abbildungsfehler der Spannungssollwerte in der Ausgangsspannung z.B. durch schwankende Zwischenkreisspannung, Totzeiteffekte, Spannungsabfälle im leitenden Zustand, Steilheit der Schaltflanken, sofort ohne Verzögerung im aktuellen Schaltzyklus kompensiert werden.

Der Modulator erzeugt im Ergebnis eine Ansteuerung des Leistungsteils höchster Qualität. Die mittlere Schaltfrequenz ist nicht konstant, sondern hängt von der Amplitude, der Frequenz und dem Winkel des Sollwerts, der Zwischenkreisspannung und den eingestellten Grenzwerten N₀, N₁, N₂ ab, die Streubandbreite ist allerdings auch nicht zu weit. Die Schaltfrequenz unterliegt durch die stochastischen Eigenschaften der verwendeten Delta-Sigma-Signale dauernden statistischen Schwankungen, auch bei stationärem Betrieb mit konstant gehaltenen Parametern, die die mittlere Schaltfrequenz bestimmen. Dieser Effekt ist durchaus positiv zu bewerten, weil die elektromagnetische Verträglichkeit des Leistungsteils durch die Streuung der Frequenzanteile im Frequenzbereich positiv beeinflusst wird und auch der akustische Eindruck eines solchen Antriebs vorteilhaft gegenüber einem solchen mit konstanter Schaltfrequenz ist.

Wenn man zum Beispiel ein Drehspannungssystem mit konstanter Amplitude und Frequenz erzeugt, entspricht der Spannungsbetrag zumindest bei Rückführung der gemessenen analogen Ausgangsspannungen exakt dem Sollwert. Die Phasennacheilung ist sehr gering, so dass bei der Stromregelung auf der Basis dies Verfahrens mit einer sehr großen Bandbreite zu rechnen ist, verglichen mit herkömmlicher abgetasteter Regelung. Bei einer mittleren Schaltfrequenz von 16 kHz wurde eine Gruppenlaufzeit des Modulators von ca. 10 µs festgestellt. Ein weiterer Vorteil der Anordnung ist darin zu sehen, dass bei dieser Art der Signalverarbeitung keine niederfrequente Abtastung im Kilohertz-Bereich mehr existiert. Da die Delta-Sigma-Signale z.B. im Bereich von 10 MHz abgetastet werden, kann man von einer quasi abtastfreien Signalverarbeitung ausgehen.

Der Modulator kann zur Stromregelung erweitert werden. Viele Antriebe und Netz-Stromrichter werden stromgeregelt betrieben. Daher ist es vorteilhaft, in den Modulator zusätzlich eine Stromregelung zu integrieren. Dies ist bei der vorliegenden Erfindung mit geringem Zusatzaufwand möglich.

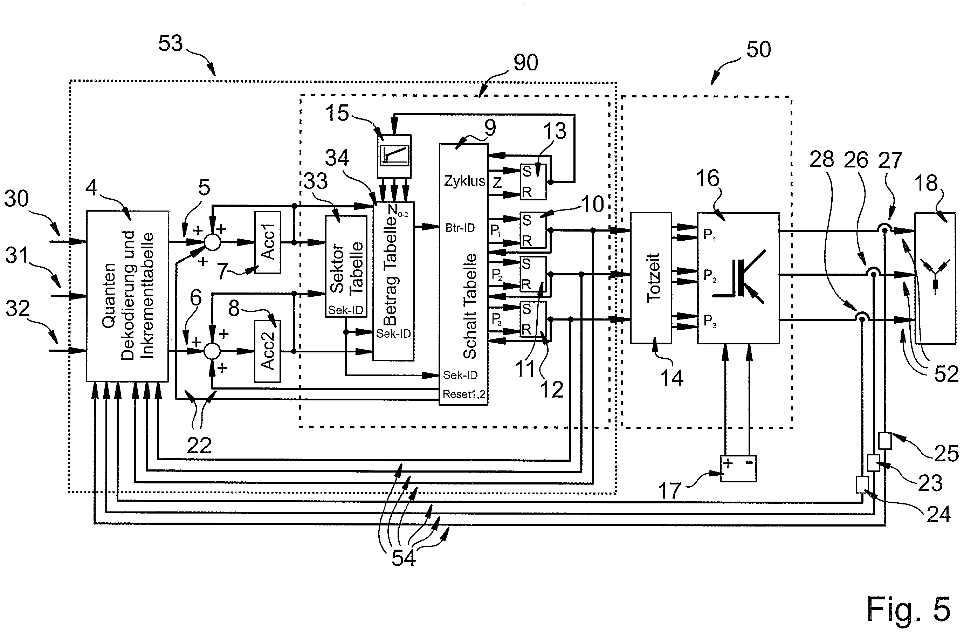

Es werden lediglich drei weitere Messwerte für die Ströme benötigt, die für eine Stromregelung aber ohnehin erforderlich sind. Die Messwerte der Ströme werden über Stromerfassungsmittel 26, 27, 28 erfasst und mit Delta-Sigma Modulatoren 23, 24, 25 in Bitstromsignale konvertiert. Die Figur 5 zeigt ein Schaltschema des Aufbaus.

Das Schaltschema gemäß Figur 5 ist weitgehend identisch mit Figur 1. Im Unterschied zu Figur 1 werden im Quantendekoder 4 drei weitere Eingänge für die Bitstromsignale der Delta-Sigma Modulatoren 23, 24, 25 vorgesehen. Als Eingangssignale und Sollwertsignale werden nun Bitströme 30, 31, 32 eingespeist, die Stromsollwerte darstellen. Für eine wirkungsvolle Stromregelung werden die Gewichte für die Stromsollwert- und die Stromistwert-Quanten deutlich z.B. um den Faktor V = 10...50 gegenüber den Quanten für die Spannungsistwerte erhöht. Die Quantendekodertabelle ist in Tabelle 4 dargestellt.

**Tabelle 4:**

| | Acc1 | Acc2 |
|---|---|---|
| Iₛₒₗₗ₁ | +V | 0 |
| Iₛₒₗₗ₂ | 0 | +V |
| Iₛₒₗₗ₃ | -V | -V |
| Iᵢₛₜ₁ | -V | 0 |
| Iᵢₛₜ₂ | 0 | -V |
| Iᵢₛₜ₃ | +V | +V |
| Uᵢₛₜ₁ | -1 | 0 |
| Uᵢₛₜ₂ | 0 | -1 |
| Uᵢₛₜ₃ | +1 | +1 |

Außerdem müssen die Grenzwerte N₀, N₁, N₂ erhöht werden, um die Schaltfrequenz nicht zu groß werden zu lassen. Die Anordnung kann man als vorgeschalteten Stromregler betrachten, der in diesem Falle als P-Regler arbeitet. Ein Vorteil der Anordnung gegenüber bekannten Lösungen ist, dass die Stromistwerte praktisch verzögerungsfrei in die Berechnung der Schaltzeitpunkte der Spannungsmodulation eingehen und dass die Begrenzung der Stromreglerausgänge automatisch durch die Art der Schaltsignalerzeugung gewährleistet ist und somit eine Ausnutzung aller Spannungsreserven bis in die Übermodulation möglich ist.

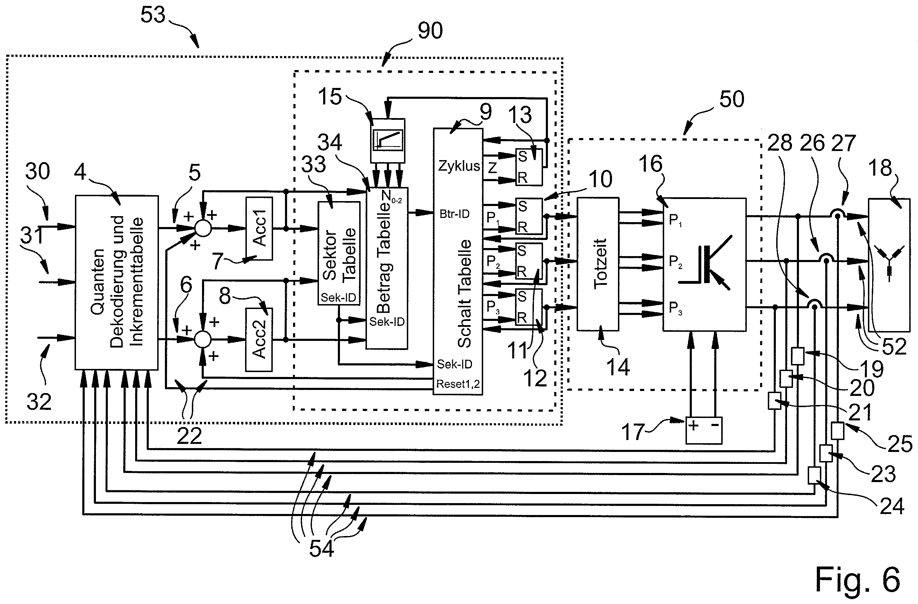

Diese Art der Stromregelung kann ebenso mit der Rückführung der gemessenen Ausgangsspannungen, wie anhand der Figur 4 erläutert, kombiniert werden, wie in Figur 6 gezeigt.

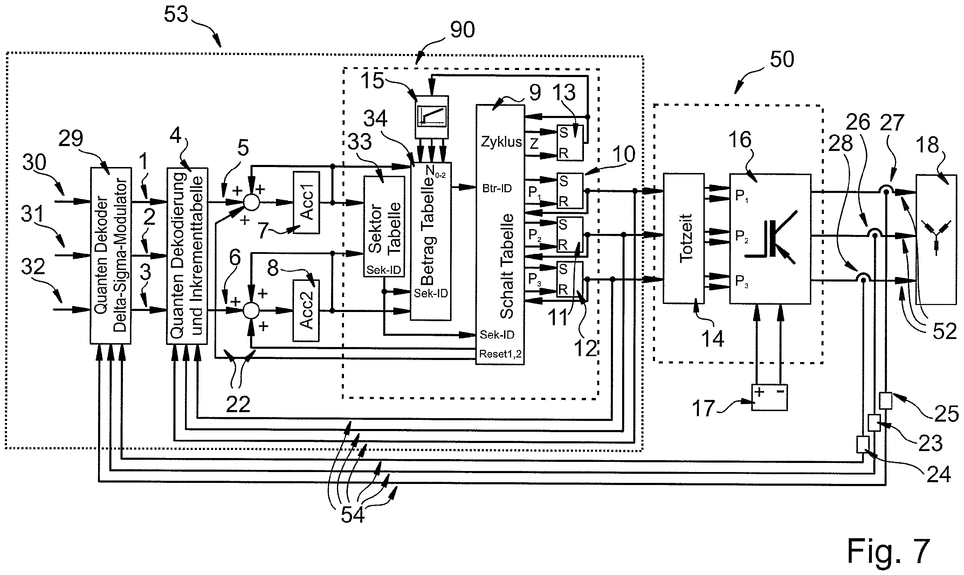

Die Stromregelung kann auch in einem unabhängigen Reglerblock erfolgen, der nicht mit der Quantendekodierung der Spannungsregelung kombiniert ist. In diesem Falle muss für die drei Komponenten des Spannungssollwertsignals ein digitaler Delta-Sigma Modulatoren eingefügt werden. Diese Konfiguration ist in Figur 7 dargestellt. Die Differenz zwischen den Stromsollwerte darstellenden Bitströmen 30, 31, 32 und den Stromistwerte darstellenden Bitströmen aus den Delta-Sigma Modulatoren 23, 24, 25 wird in einem Block 29 mittels eines Quantendekoders mit Inkrementtabelle und nachfolgenden digitalen Delta-Sigma Modulatoren gebildet. Dabei wird gleichzeitig durch einen hinreichend großen Verstärkungsfaktor V eine Proportionalverstärkung erzeugt. Der übrige Teil der Struktur bleibt wie vorher beschrieben.

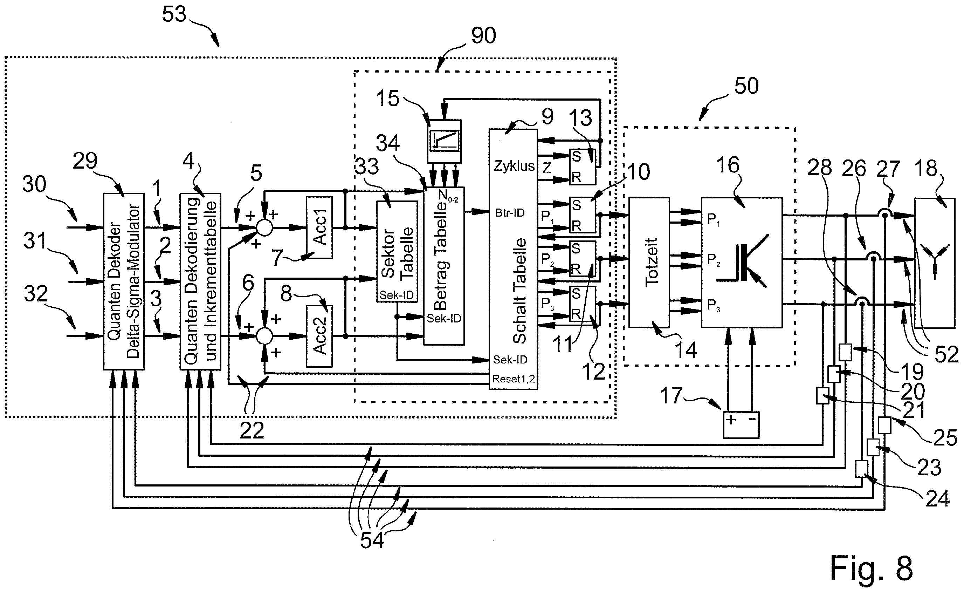

Die Schaltung kann weiter modifiziert werden, indem wiederum für die Spannungsrückführung die Analogwerte der Phasenpotentiale am Leistungsteil verwendet werden, wie anhand der Figur 4 erläutert, und über Delta-Sigma Modulatoren in den Quantendekoder 4 des Spannungsregelkreises eingespeist werden. Diese Konfiguration ist in Figur 8 gezeigt.

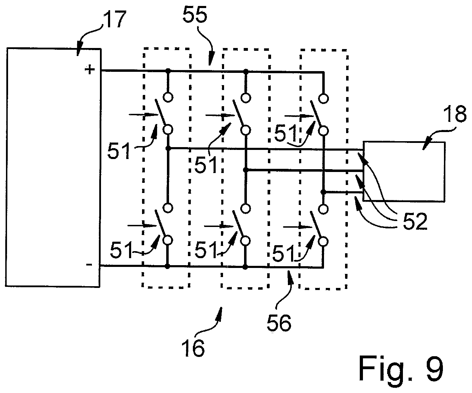

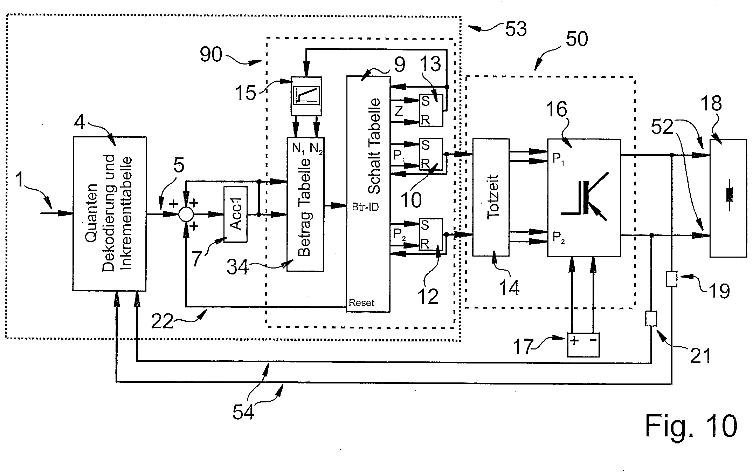

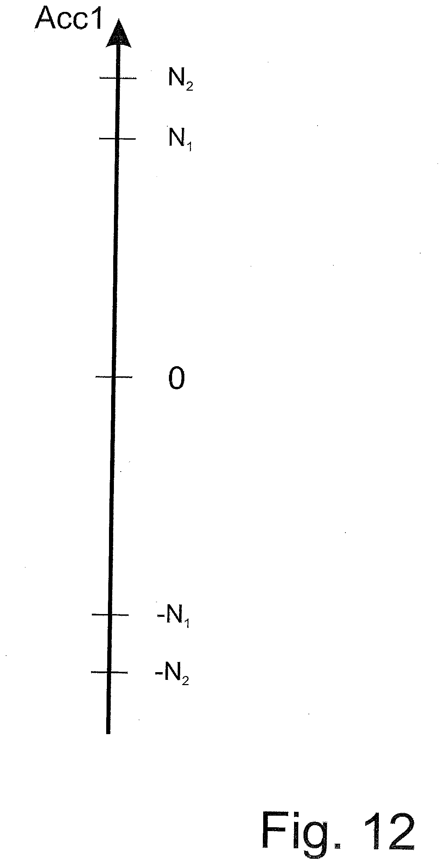

Nachfolgend wird anhand der Figuren 10 bis 12 eine zweiphasige Ausführungsform des Stromrichters erläutert, wie sie z.B. für die Ansteuerung zweipoliger Lasten wie Gleichstrommotoren oder eines Wicklungsstrangs eines Schrittmotors vorteilhaft ist. Das Leistungsteil 16 eines solchen Stromrichters entspricht grundsätzlich dem Aufbau gemäß Figur 9, wobei eine der drei Halbbrücken fehlt und die Last 18 entsprechend nur zwei Anschlüsse aufweist. Dementsprechend sind auch nur zwei Leistungsausgänge 52 vorhanden, an die die Last 18 mit ihren zwei Anschlüssen angeschlossen ist. In einem solchen Fall vereinfacht sich das Raumzeigerdiagramm, wie es in den Figuren 2 und 3 dargestellt ist, zu einer skalaren Darstellung, wie in Figur 12 wiedergegeben ist. Es wird in diesem Fall nur ein Digitalakkumulator Acc1 benötigt. Es entfällt ferner der untere Grenzwert N₀. Vorteilhafterweise können weiterhin die Grenzwerte N₁, N₂ beibehalten werden, mit einer vergleichbaren Funktion wie zuvor beschrieben.

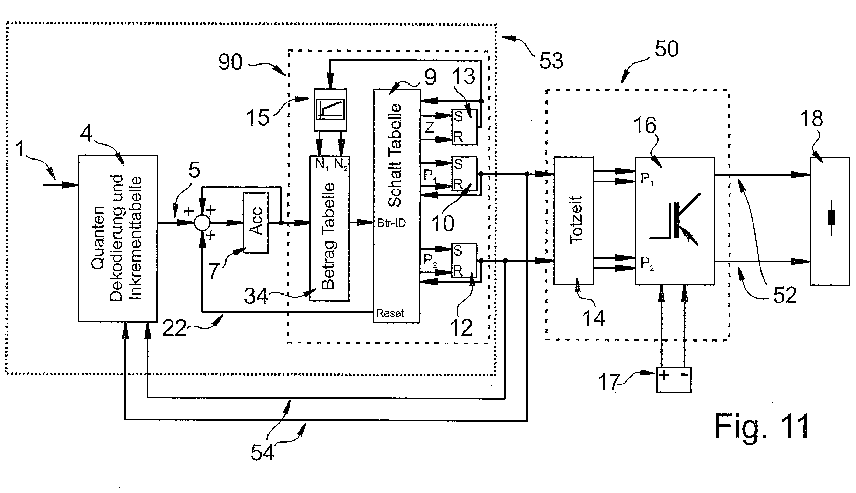

Die zuvor anhand der Figuren 1 bis 8 beschriebenen Ausführungsformen eines Stromrichters in dreiphasiger Ausführung können bei der zweiphasigen Ausführungsform übernommen werden, wobei sich Vereinfachungen realisieren lassen. Dies ist anhand zweier Ausführungsbeispiele, die in den Figuren 10 und 11 bildlich wiedergegeben sind, beispielhaft dargestellt. In entsprechender Weise können auch die anderen, zuvor erläuterten dreiphasigen Ausführungsformen mit ihren Merkmalen für die zweiphasige Ausführungsform mit den entsprechenden Vereinfachungen übernommen werden.

Das als Eingangssignal zugeführte Sollwertsignal kann bei der zweiphasigen Ausführungsform durch einen einzigen Bitstrom 1 bereitgestellt werden. Es können auch zwei Bitströme zugeführt werden, wobei der eine Bitstrom die Inverse des anderen Bitstroms darstellt. Insofern kann z.B. der eine Bitstrom 1, wie in den Figuren 10 und 11 dargestellt, von außen zugeführt werden und intern, z.B. im Quantendekoder 4, zusätzlich als invertierter Bitstrom bereitgestellt werden. Es kann auch ein externer Inverter zur Erzeugung des zweiten, invertierten Bitstroms mit dem Bitstrom 1 gekoppelt werden.

Im Unterschied zur dreiphasigen Ausführungsform kann, wie erwähnt, ein Digitalackumulator entfallen. Dementsprechend ist in den Figuren 10 und 11 nur der eine Digitalakkumulator 7 (Acc1) wiedergegeben. Infolgedessen kann auch die zuvor erläuterte Sektortabelle 33 entfallen. Im Schaltwerk 90 ergeben sich weitere Vereinfachungen, z.B. durch Fortfall eines Flipflops (hier beispielhaft Flipflop 11), sowie hinsichtlich der Schalttabelle 9 und der Betragstabelle 34.

Im Übrigen zeigt die Figur 10 eine mit der Ausführungsform gemäß Figur 4 vergleichbare zweiphasige Ausführungsform, d.h. mit einer Rückführung der gemessenen analogen Spannungen an Stelle der internen Zustandsbits. Die analogen Spannungen werden auch hier wiederum über analoge Delta-Sigma-Modulatoren 19, 21 digitalisiert und als Bitströme 54 zum Quantendekoder 4 zurückgeführt.

Die Ausführungsform gemäß Figur 11 ist eine zweiphasige Ausführungsform der zuvor erläuterten Ausführungsform gemäß Figur 1, d.h. mit interner Rückführung der digitalen Ausgangssignale der Flipflops 10, 12. Wie erkennbar ist, können auch die anderen dreiphasigen Ausführungsformen in entsprechender Weise in zweiphasige Ausführungsformen vereinfacht werden.

Bei der zweiphasigen Ausführungsform kann die Schalttabelle 9, wie zuvor in Tabelle 1 für die dreiphasige Ausführungsform wiedergegeben, gemäß folgender Tabelle vereinfacht werden.

**Tabelle 5:**

| Schaltvektor <P₂,P₁> | Typ |
|---|---|
| <0,0> | Null |
| <1,1> | Null |
| <0,1> | Aktiv |
| <1,0> | Aktiv |

Die bei der dreiphasigen Ausführungsform zuvor in Tabelle 2 wiedergegebene Quantentabelle im Quantendekoder 4 kann nun wie folgt dargestellt werden.

**Tabelle 6:**

| | Acc1 |
|---|---|
| U1Soll | +1 |
| U1Ist | -1 |
| U2Ist | +1 |

Die in der Betragstabelle 34 eingesetzte Tabelle kann wie folgt angegeben werden.

**Tabelle 7:**

| | Betrag-ID |
|---|---|
| 0<=Acc1<=N₁ | 1 |
| N₁<Acc1<=N₁ | 2 |
| N₁<Acc1 | 3 |
| -N₁<=Acc1 <0 | 4 |
| -N₁<=Acc1<-N₁ | 5 |
| Acc1<-N₁ | 6 |

Mit der Betragstabelle 34 wird somit der in Figur 12 dargestellte Zahlenstrahl in 6 Bereiche aufgeteilt, die durch die Ausgangsgröße der Betragstabelle 34 zahlenmäßig kodiert werden. Die Ausgangsgröße der Betragstabelle 34 ist dann eine Betragsidentifikation, auch Betrags-ID oder BTR-ID genannt, über die durch zahlenmäßige Kodierung angegeben wird, in welchem Werteintervall sich der Inhalt des Digitalakkumulators Acc1 befindet.

Durch zusätzliche Berücksichtigung des Zyklusbits Z, für das ausgangsseitig der Schalttabelle 9 das Flipflop 13 vorgesehen ist, können die erzeugten Betätigungssignale der Halbleiterschalter unter Berücksichtigung der zuvor aufgeführten Schalttabelle 9 wie folgt erzeugt und damit gleichmäßig auf die Halbleiterschalter verteilt werden.

Es sei unter Bezug auf Figur 12 zunächst davon ausgegangen, dass ein positiver Sollwert vorliegt, d.h. das als Eingangssignal zugeführte Sollwertsignal in Form des Bitstroms 1 gibt einen positiven Spannungssollwert vor. Bezüglich des aus den zwei Betätigungssignal-Bits P₂, P₁ und des Zyklusbits Z gebildeten Vektors <P₂, P₁, Z> wird zunächst von einem Startwert von <0,0,0> ausgegangen. Es sei angenommen, dass der Digitalakkumulator Acc1 nun zu positiven Werten hin läuft, d.h. in der Darstellung der Figur 12 von 0 aus nach oben hin. Wird dann der Grenzwert N₁ überschritten, wird durch das Schaltwerk 90, insbesondere die Schalttabelle 9, ein aktiver Vektor <P₂, P₁, Z> = <0,1,0> erzeugt. Dies führt durch die Verarbeitung im Schaltwerk dazu, dass der Digitalakkumulator Acc1 wieder in Richtung kleinerer Werte, d.h. in Richtung 0 läuft. Unterschreitet der Digitalakkumulator Acc1 dabei die Null-Grenze, wird ein 0-Vektor <P₂, P₁, Z> = <1,1,1> erzeugt. Dies führt wiederum dazu, dass der Digitalakkumulator Acc1 in Richtung positiver Werte läuft. Beim Überschreiten des Grenzwerts N₁ wird wiederum der aktive Vektor <P₂, P₁, Z> = <0,1,1> erzeugt, diesmal mit gesetztem Zyklusbit Z = 1. Es wird damit hinsichtlich des am Leistungsausgang zu erzeugenden Wechselstroms bzw. der entsprechenden Wechselspannung der gleiche Effekt erzeugt wie zuvor beim erstmalig geschalteten aktiven Vektor, aber es wird ein anderer Halbleiterschalter betätigt. Hiernach läuft der Digitalakkumulator Acc1 wieder in Richtung 0. Beim Unterschreiten des Werts 0 wird, erkannt aufgrund des gesetzten Zyklusbits Z = 1, nun ein anderer Null-Vektor <P₂, P₁, Z> = <0,0,0> erzeugt. Bei weiterhin vorliegendem positiven Sollwert im zugeführten Bitstrom 1 beginnt der eben beschriebene Zyklus wiederum von vorne, d.h. das Zyklusbit ist nun nicht gesetzt. Dementsprechend wird der zuerst genannte aktive Vektor erzeugt, usw.

Bei negativem Sollwert, charakterisiert durch den Bitstrom 1, findet ein sinngemäß gleicher Vorgang statt, jedoch mit invertierten Vorzeichen. Der Digitalakkumulator Acc1 befindet sich dabei zwischen dem Wert 0 und dem Grenzwert -N₁. Es wird zunächst beim Unterschreiten des Grenzwertes -N₁ der aktive Vektor <P₂, P₁, Z> = <1,0,0> erzeugt, und nach Rücklauf des Digitalakkumulators Acc1 zum Wert 0 und weiterem Unterschreiten des Grenzwertes -N₁ derselbe aktive Vektor <P₂, P₁, Z> = <1,0,1>, diesmal mit gesetztem Zyklusbit Z = 1. Entsprechend werden auch die Null-Vektoren gewechselt. Dieser Wechsel zwischen Null-Vektoren wird durch das Zyklusbit Z gesteuert.

Es kann auch hier eine Übersteuerung auftreten. Ist der Betrag des als Eingangssignal zugeführten Sollwertsignals so groß, dass der Digitalakkumulator Acc1 nach dem Schalten des aktiven Vektors dennoch den Grenzwert N₂ überschreitet (bzw. - N₂ unterschreitet), so wird eine feste Anzahl von Inkrementen im Digitalakkumulator Acc1 abgezogen, die den Digitalakkumulator Acc1 wieder in den Bereich zwischen den Grenzwerten N₁ und N₂ zurück bringt, insbesondere in einem Bereich nahe N₁ oder etwas oberhalb des Grenzwerts N₁. Bei negativem Sollwertsignal wird im Prinzip die gleiche Funktion durchgeführt, nur mit negativen Vorzeichen sowie den negativen Grenzwerten -N₁ und -N₂. Gemäß einer vorteilhaften Ausgestaltung der Erfindung kann die Differenz der Grenzwerte N₁ und N₂ sehr klein gewählt werden. Dementsprechend wird der maximal auftretende Wert des Digitalakkumulators Acc1 hart auf einen oberen Grenzwert im Bereich von N₂ bzw. -N₂ begrenzt.

Auch bei der hier beschriebenen zweiphasigen Ausführungsform kann die Schaltfrequenz beeinflusst werden. Die Schaltfrequenz hängt in starkem Maße vom Betrag des Eingangssignals ab. Bei Betragswerten des Eingangssignals nahe Null wird die Schaltfrequenz relativ klein. Eine entsprechende Dynamik der erzeugten Betätigungssignale liegt dennoch vor, weil bei einer Spannungsanforderung beispielsweise aus einem übergeordneten Stromregelkreis der Betrag der Spannungsanforderung schnell ansteigt und einen Schaltvorgang auslöst.

Wie bei der dreiphasigen Ausführungsform kann auch bei der zweiphasigen Ausführungsform ein äußerer Stromregelkreis vorgesehen werden, wie z.B. bei der dreiphasigen Ausführungsform in Figur 5 dargestellt. Eine dann verwendete Quantendekodertabelle, bei der dreiphasigen Ausführungsform in Tabelle 4 angegeben, kann dann wie folgt aussehen.

**Tabelle 8:**

| | Acc1 |
|---|---|
| Iₛₒₗₗ₁ | +V |
| Iᵢₛₜ₁ | -V |
| Uᵢₛₜ₁ | -1 |
| Uᵢₛₜ₂ | 1 |

Der Stromregelkreis kann entweder direkt in den Quantendekoder der Spannungsrückführung integriert sein, mit unterschiedlicher Verstärkung der Quanten aus dem Spannungs- und Stromsignalen, oder als zusätzliche Regelschleife mit eigenem Quantendekoder und anschließendem digitalen Delta-Sigma-Modulator.

Die übrigen in den Figuren 10 und 11 dargestellten Funktionsblöcke entsprechen in ihrer Funktion und Beschreibung den zuvor für die dreiphasige Ausführungsform beschriebenen Merkmalen, mit dem Unterschied, dass nur zwei Betätigungssignale P₂, P₁ erzeugt und verarbeitet werden.

## Patentansprüche

1. Mehrphasiger Stromrichter (50) zur Abgabe von mehrphasigem Wechselstrom, wobei der Stromrichter (50) für jede Phase des mehrphasigen Wechselstroms einen über wenigstens zwei in Halbbrückenschaltung geschaltete Halbleiterschalter (51) gesteuerten Leistungsausgang (52) aufweist, wobei der Stromrichter (50) eine Steuereinrichtung (53) aufweist, die zur Verarbeitung eines der Steuereinrichtung (53) als Eingangssignal zugeführten Sollwertsignals in Form jeweils eines ein Bit oder mehrere Bits breiten Bitstroms (1, 2, 3, 30, 31, 32) ,
bei dem die darin enthaltene Information durch einen Mittelwert über eine Folge von aufeinander folgenden Bits des Bitstroms repräsentiert wird, für jede Phase eingerichtet ist, wobei die Steuereinrichtung (53) zur Erzeugung von Betätigungssignalen (P₁, P₂, P₃) der Halbleiterschalter (51) in Abhängigkeit von den als Eingangssignal zugeführten Bitströmen (1, 2, 3, 30, 31, 32) mittels Raumzeigermodulation eingerichtet ist, wobei die Raumzeigermodulation eine Winkelhysterese und/oder eine Betragshysterese des Spannungsraumzeigers aufweist, wobei ein Schaltwerk zur Erzeugung von Schaltsequenzen der Raumzeigermodulation vorhanden ist, das zusätzlich zu Zustandsbits, die den Ausgangs-Schaltsignalen und damit den Betätigungssignalen (P₁, P₂, P₃) der Halbleiterschalter (51) entsprechen, wenigstens ein zusätzliches Bit in Form eines Zyklusbits aufweist, das die Laufrichtung im Zyklus des Spannungsraumzeigers angibt, wobei die Winkelhysterese mittels des Zyklusbits realisiert ist.

2. Stromrichter nach Anspruch 1, **dadurch gekennzeichnet, dass** die Raumzeigermodulation einen oder mehrere Grenzwerte (N₀, N₁, N₂) aufweist, wobei die Steuereinrichtung (53) einen Vergleicher aufweist, der zum Vergleichen des Betrags des Spannungsraumzeigers mit dem Grenzwert oder den Grenzwerten (N₀, N₁, N₂) und zum Auslösen einer Schaltfunktion in dem Falle eingerichtet ist, dass der Betrag des Spannungsraumzeigers einen solchen Grenzwert (N₀, N₁, N₂) überschreitet.

3. Stromrichter nach dem vorhergehenden Anspruch, **dadurch gekennzeichnet, dass** die Steuereinrichtung (53) zur variablen Änderung des Grenzwerts oder der Grenzwerte (N₀, N₁, N₂) in Abhängigkeit von dem jeweiligen als Eingangssignal zugeführten Sollwertsignal und/oder dem Betrag des Spannungsraumzeigers eingerichtet ist.

4. Stromrichter nach Anspruch 2 oder 3, **dadurch gekennzeichnet, dass** die Steuereinrichtung (53) dazu eingerichtet ist, bei Überschreitung des höchsten Grenzwerts (N₀, N₁, N₂) ein Rücksetzsignal (22) zur gezielten Reduzierung von in Digitalakkumulatoren (7, 8) der Steuereinrichtung (53) gespeicherten Werten durchzuführen.

5. Stromrichter nach einem der vorhergehenden Ansprüche, **dadurch gekennzeichnet, dass** die Steuereinrichtung (53) dazu eingerichtet ist, die als Eingangssignal zugeführten Bitströme (1, 2, 3, 30, 31, 32) digital mit von zurückgeführten Ausgangssignalen der Steuereinrichtung (53) abgeleiteten Bitströmen (54) zu verarbeiten, wobei jedem als Eingangssignal zugeführten Bitstrom (1, 2, 3, 30, 31, 32) ein von einem zurückgeführten Ausgangssignal der Steuereinrichtung abgeleiteter Bitstrom (54) des jeweiligen Leistungsausgangs (52) zugeordnet ist, wobei der Stromrichter (50) Delta-Sigma-Modulatoren (19, 20, 21, 23, 24, 25) zur Erzeugung der von zurückgeführten Ausgangssignalen der Steuereinrichtung abgeleiteten Bitströme (54) aufweist, wobei die Delta-Sigma-Modulatoren (19, 20, 21, 23, 24, 25) zur Umwandlung der an den Leistungsausgängen abgegebenen analogen Spannungen und/oder Ströme in ein Bit breite Bitströme eingerichtet ist.

6. Stromrichter nach einem der vorhergehenden Ansprüche, **dadurch gekennzeichnet, dass** der Stromrichter (50) zur Stromregelung der über die Leistungsausgänge abgegebenen Ströme eingerichtet ist.

7. Stromrichter nach einem der vorhergehenden Ansprüche, **dadurch gekennzeichnet, dass** die Steuereinrichtung (53) eine Regeleinheit (15) aufweist, die dazu eingerichtet ist, die mittlere Schaltfrequenz der Ausgangssignale der Leistungsausgänge (52) zu bestimmen und eine Regelung der mittleren Schaltfrequenz auf einen vorgegebenen Sollwert durchzuführen.

8. Stromrichter nach einem der vorhergehenden Ansprüche, **dadurch gekennzeichnet, dass** die Steuereinrichtung (53) eingangsseitig einen Quantendekoder (4, 29) in Kombination mit einer Inkrementabelle aufweist, die dazu eingerichtet ist, die als Eingangssignal zugeführten Bitströme (1, 2, 3, 30, 31, 32) in Quanten zu dekodieren und vorzeichenrichtig zu Inkrementen zu summieren.

9. Stromrichter nach dem vorhergehenden Anspruch, **dadurch gekennzeichnet, dass** die Steuereinrichtung (53) wenigstens zwei Digitalakkumulatoren (7, 8) aufweist, die der Inkrementabelle nachgeschaltet sind, wobei die Digitalakkumulatoren (7, 8) dazu eingerichtet sind, die von der Inkrementabelle abgegebenen Inkremente aufzusummieren.

10. Stromrichter nach dem einem der vorhergehenden Ansprüche, **dadurch gekennzeichnet, dass** die Steuereinrichtung (53) zur Erzeugung von Betätigungssignalen (P₁, P₂) der Halbleiterschalter (51) in Abhängigkeit von dem Bitstrom oder den Bitströmen (1, 2, 3, 30, 31, 32) mittels eines Schaltwerks eingerichtet ist, das zur Erzeugung von Schaltsequenzen der Betätigungssignale (P₁, P₂) eingerichtet ist, durch die die Belastung der Halbleiterschalter (51) im zeitlichen Mittel gleichmäßig auf die Halbleiterschalter (51) verteilt ist, **dadurch gekennzeichnet, dass** die Steuereinrichtung (53) eine Schalttabelle (9) aufweist.

11. Stromrichter nach dem einem der vorhergehenden Ansprüche, **dadurch gekennzeichnet, dass** die Steuereinrichtung (53) dazu eingerichtet ist, den als Eingangssignal zugeführten Bitstrom (1, 2, 3, 30, 31, 32) oder die als Eingangssignal zugeführten Bitströme (1, 2, 3, 30, 31, 32) digital mit von zurückgeführten Ausgangssignalen der Steuereinrichtung (53) abgeleiteten Bitströmen (54) zu verarbeiten, wobei der Stromrichter (50) Delta-Sigma-Modulatoren (19, 20, 21, 23, 24, 25) zur Erzeugung der von zurückgeführten Ausgangssignalen der Steuereinrichtung abgeleiteten Bitströme (54) aufweist, wobei die Bitstromerzeugungsmittel (19, 20, 21, 23, 24, 25) zur Umwandlung der an den Leistungsausgängen abgegebenen analogen Spannungen und/oder Ströme in ein Bit breite Bitströme eingerichtet ist.

12. Stromrichter nach dem vorhergehenden Anspruch, **dadurch gekennzeichnet, dass** die Steuereinrichtung (53) einen oder mehrere Grenzwerte (N₁, N₂) aufweist, wobei die Steuereinrichtung (53) einen Vergleicher aufweist, der zum Vergleichen des im Digitalakkumulator (7, 8) aufsummierten Werts oder eines daraus bestimmten Werts mit dem Grenzwert oder den Grenzwerten (N₁, N₂) und zum Auslösen einer Schaltfunktion in dem Falle eingerichtet ist, dass dabei ein solcher Grenzwert (N₁, N₂) überschritten ist.

13. Stromrichter nach dem vorhergehenden Anspruch, **dadurch gekennzeichnet, dass** die Steuereinrichtung (53) zur variablen Änderung des Grenzwerts oder der Grenzwerte (N₁, N₂) in Abhängigkeit von dem jeweiligen als Eingangssignal zugeführten Sollwertsignal und/oder dem im Digitalakkumulator (7, 8) aufsummierten Wert oder einem daraus bestimmten Wert eingerichtet ist.

14. Computerprogramm zur Steuerung eines mehrphasigen Stromrichters (50) zur Abgabe von mehrphasigem Wechselstrom, wobei der Stromrichter (50) für jede Phase des mehrphasigen Wechselstroms einen über wenigstens zwei in Halbbrückenschaltung geschaltete Halbleiterschalter gesteuerten Leistungsausgang (52) aufweist, wobei das Computerprogramm Programmcodemittel aufweist, eingerichtet zur Durchführung des folgenden Verfahrens, wenn das Computerprogramm auf einem Rechner des Stromrichters (50) ausgeführt wird:
- Verarbeiten eines dem Stromrichter (50) als Eingangssignal zugeführten Sollwertsignals in Form jeweils eines ein Bit oder mehrere Bits breiten Bitstroms (1, 2, 3, 30, 31, 32), bei dem die darin enthaltene Information durch einen Mittelwert über eine Folge von aufeinander folgenden Bits des Bitstroms repräsentiert wird, für jede Phase,
- Erzeugen von Betätigungssignalen (P₁, P₂, P₃) der Halbleiterschalter in Abhängigkeit von den als Eingangssignal zugeführten Bitströmen (1, 2, 3, 30, 31, 32) mittels Raumzeigermodulation, wobei die Raumzeigermodulation eine Winkelhysterese und/oder eine Betragshysterese des Spannungsraumzeigers aufweist, wobei ein Schaltwerk zur Erzeugung von Schaltsequenzen der Raumzeigermodulation vorhanden ist, das zusätzlich zu Zustandsbits, die den Ausgangs-Schaltsignalen und damit den Betätigungssignalen (P₁, P₂, P₃) der Halbleiterschalter (51) entsprechen, wenigstens ein zusätzliches Bit in Form eines Zyklusbits aufweist, das die Laufrichtung im Zyklus des Spannungsraumzeigers angibt, wobei die Winkelhysterese mittels des Zyklusbits realisiert ist.

15. Computerprogramm nach dem einem der vorhergehenden Ansprüche, **gekennzeichnet durch**:
- Erzeugen von Betätigungssignalen (P₁, P₂) der Halbleiterschalter in Abhängigkeit von dem Bitstrom oder den Bitströmen (1, 2, 3, 30, 31, 32), indem Schaltsequenzen der Betätigungssignale (P₁, P₂) erzeugt werden, durch die die Belastung der Halbleiterschalter (51) im zeitlichen Mittel gleichmäßig auf die Halbleiterschalter (51) verteilt ist,
wobei zusätzlich zu Zustandsbits, die den Ausgangs-Schaltsignalen und damit den Betätigungssignalen (P₁, P₂) der Halbleiterschalter (51) entsprechen, wenigstens ein zusätzliches Bit in Form eines Zyklusbits bestimmt wird, durch das die Belastung der Halbleiterschalter (51) im zeitlichen Mittel gleichmäßig auf die Halbleiterschalter (51) verteilt wird.

## Claims

1. Multiphase converter (50) for delivering multiphase alternating current, the converter (50) having a power output (52) controlled by at least two semiconductor switches (51) connected in a half-bridge circuit for each phase of the multiphase alternating current, the converter (50) having a control device (53), which is set up to process a setpoint signal supplied to the control device (53) for each phase as an input signal in the form of a respective bit stream (1, 2, 3, 30, 31, 32) which is one or more bits wide and in which the information contained therein is represented by an average value over a sequence of successive bits of the bit stream, the control device (53) being arranged to generate actuation signals (P1, P2, P3) of the semiconductor switches (51) by means of space vector modulation as a function of the bit streams (1, 2, 3, 30, 31, 32) supplied as input signal, the space vector modulation having an angular hysteresis and/or a magnitude hysteresis of the voltage space vector, a switching mechanism for generating switching sequences of the space vector modulation being present, which, in addition to state bits corresponding to the output switching signals and thus to the actuation signals (P1, P2, P3) of the semiconductor switches (51), has at least one additional bit in the form of a cycle bit which indicates the direction of travel in the cycle of the voltage space vector, the angular hysteresis being realized by means of the cycle bit.

2. The power converter according to claim 1, **characterized in that** the space vector modulation comprises one or more limit values (N0, N1, N2), wherein the control device (53) comprises a comparator which is arranged to compare the magnitude of the voltage space vector with the limit value or values (N0, N1, N2) and to trigger a switching function in the event that the magnitude of the voltage space vector exceeds such a limit value (N0, N1, N2).

3. Converter according to the preceding claim, **characterized in that** the control device (53) is set up for variably changing the limit value or limit values (N0, N1, N2) as a function of the respective setpoint signal supplied as an input signal and/or the magnitude of the voltage space vector.

4. Converter according to claim 2 or 3, **characterized in that** the control device (53) is set up to carry out a reset signal (22) for selectively reducing values stored in digital accumulators (7, 8) of the control device (53) when the highest limit value (N0, N1, N2) is exceeded.

5. Converter in accordance with one of the preceding claims, **characterized in that** the control device (53) is set up to process the bit streams (1, 2, 3, 30, 31, 32) supplied as input signal digitally with bit streams (54) derived from returned output signals of the control device (53), each bit stream (1, 2, 3, 30, 31, 32) supplied as input signal is assigned to a bit stream (54) derived from a returned output signal of the control device of the respective power output (52), the converter (50) having delta-sigma modulators (19, 20, 21, 23, 24, 25) for generating the bit streams (54) derived from returned output signals of the control device, the delta-sigma modulators (19, 20, 21, 23, 24, 25) being set up for converting the analog voltages and/or currents output at the power outputs into one bit-wide bit streams.

6. Power converter according to one of the preceding claims, **characterized in that** the power converter (50) is arranged for current control of the currents delivered via the power outputs.

7. Converter according to one of the preceding claims, **characterized in that** the control device (53) has a control unit (15) which is set up to determine the average switching frequency of the output signals of the power outputs (52) and to carry out a control of the average switching frequency to a predetermined setpoint value.

8. Power converter according to one of the preceding claims, **characterized in that** the control unit (53) has a quantum decoder (4, 29) on the input side in combination with an increment table which is set up to decode the bit streams (1, 2, 3, 30, 31, 32) supplied as input signal into quanta and to add them together with the correct sign to form increments.

9. Converter according to the preceding claim, **characterized in that** the control device (53) has at least two digital accumulators (7, 8) which are connected downstream of the increment table, the digital accumulators (7, 8) being set up to sum up the increments output by the increment table.

10. Converter according to one of the preceding claims, **characterized in that** the control device (53) is arranged to generate actuation signals (P1, P2) of the semiconductor switches (51) as a function of the bit stream or streams (1, 2, 3, 30, 31, 32) by means of a switching mechanism, which is set up to generate switching sequences of the actuating signals (P1, P2) by which the load on the semiconductor switches (51) is distributed uniformly over the semiconductor switches (51) on a time average, **characterized in that** the control device (53) has a switching table (9).

11. Converter according to one of the preceding claims, **characterized in that** the control device (53) is set up to process the bit stream (1, 2, 3, 30, 31, 32) supplied as an input signal or the bit streams (1, 2, 3, 30, 31, 32) supplied as an input signal digitally with bit streams (54) derived from output signals fed back to the control device (53), wherein the converter (50) comprises delta-sigma modulators (19, 20, 21, 23, 24, 25) for generating the bit streams (54) derived from returned output signals of the control device, wherein the bit stream generating means (19, 20, 21, 23, 24, 25) is arranged for converting the analog voltages and/or currents delivered at the power outputs into one bit-wide bit streams.

12. Converter according to the preceding claim, **characterized in that** the control device (53) has one or more limit values (N1, N2), the control device (53) having a comparator which is set up to compare the value accumulated in the digital accumulator (7, 8) or a value determined therefrom with the limit value or limit values (N1, N2) and to trigger a switching function in the event that such a limit value (N1, N2) is exceeded.

13. Converter according to the preceding claim, **characterized in that** the control device (53) is set up for variably changing the limit value or limit values (N1, N2) as a function of the respective setpoint signal supplied as an input signal and/or the value accumulated in the digital accumulator (7, 8) or a value determined therefrom.

14. A computer program for controlling a multi-phase converter (50) for delivering multi-phase alternating current, the converter (50) having a power output (52) for each phase of the multi-phase alternating current which is controlled via at least two semiconductor switches connected in a half-bridge circuit, the computer program having program code means arranged to carry out the following procedure when the computer program is executed on a computer of the converter (50):
- processing, for each phase, a setpoint signal supplied to the converter (50) as an input signal in the form of a bit stream (1, 2, 3, 30, 31, 32) which is one or more bits wide, in which the information contained therein is represented by an average value over a sequence of successive bits of the bit stream,
- generation of actuation signals (P1, P2, P3) of the semiconductor switches as a function of the bit streams (1, 2, 3, 30, 31, 32) supplied as input signal by means of space vector modulation, the space vector modulation having an angular hysteresis and/or a magnitude hysteresis of the voltage space vector, a switching mechanism for generating switching sequences of the space vector modulation being present, which, in addition to state bits corresponding to the output switching signals and thus to the actuation signals (P1, P2, P3) of the semiconductor switches (51), has at least one additional bit in the form of a cycle bit which indicates the direction of travel in the cycle of the voltage space vector, the angular hysteresis being realized by means of the cycle bit.

15. Computer program according to one of the preceding claims, **characterized by**:
- generating actuation signals (P1, P2) of the semiconductor switches as a function of the bit stream or streams (1, 2, 3, 30, 31, 32) by generating switching sequences of the actuation signals (P1, P2) by which the load on the semiconductor switches (51) is distributed uniformly over the semiconductor switches (51) on a time average,
wherein, in addition to state bits corresponding to the output switching signals and thus to the actuation signals (P1, P2) of the semiconductor switches (51), at least one additional bit in the form of a cycle bit is determined, by which the load on the semiconductor switches (51) is distributed uniformly over the semiconductor switches (51) on a time average.

## Revendications

1. Convertisseur multiphasé (50) pour fournir un courant alternatif multiphasé, le convertisseur (50) ayant une sortie de puissance (52) commandée par au moins deux commutateurs à semi-conducteur (51) montés dans un circuit en demi-pont pour chaque phase du courant alternatif multiphasé, le convertisseur (50) ayant un dispositif de commande (53) qui est conçu pour traiter un signal de consigne fourni au dispositif de commande (53) en tant que signal d'entrée sous la forme d'un flux de bits (1, 2, 3, 30, 31, 32) ayant la largeur d'un bit ou de plusieurs bits pour chaque phase, flux dans lequel l'information y contenue est représentée par une valeur moyenne sur une succession de bits successifs du flux binaire, le dispositif de commande (53) étant conçu pour générer des signaux d'actionnement (P₁, P₂, P₃) des commutateurs à semi-conducteur (51) en fonction des flux de bits (1, 2, 3, 30, 31, 32) fournis en tant que signal d'entrée à l'aide d'une modulation du vecteur spatial,
dans lequel
la modulation du vecteur spatial présente une hystérésis angulaire et/ou une hystérésis de valeur du vecteur spatial de tension,
il existe un mécanisme de commutation pour générer des séquences de commutation de la modulation du vecteur spatial, qui, en plus des bits d'état qui correspondent aux signaux de commutation de sortie et donc aux signaux d'actionnement (P₁, P₂, P₃) des commutateurs à semi-conducteur (51), présente au moins un bit supplémentaire sous la forme d'un bit de cycle qui indique le sens du mouvement dans le cycle du vecteur spatial de tension, et
l'hystérésis angulaire est réalisée à l'aide du bit de cycle.

2. Convertisseur selon la revendication 1,
**caractérisé en ce que**
la modulation du vecteur spatial présente une ou plusieurs valeurs limites (N₀, N₁, N₂), le dispositif de commande (53) présentant un comparateur qui est conçu pour comparer la valeur du vecteur spatial de tension avec la valeur limite ou les valeurs limites (N₀, N₁, N₂) et pour déclencher une fonction de commutation dans le cas où la valeur du vecteur spatial de tension dépasse une telle valeur limite (N₀, N₁, N₂).

3. Convertisseur selon la revendication précédente,
**caractérisé en ce que** le dispositif de commande (53) est conçu pour modifier de manière variable la valeur limite ou les valeurs limites (N₀, N₁, N₂) en fonction du signal de consigne respectif fourni comme signal d'entrée et/ou en fonction de la valeur du vecteur spatial de tension.

4. Convertisseur selon la revendication 2 ou 3,
**caractérisé en ce que** le dispositif de commande (53) est conçu pour appliquer un signal de réinitialisation (22) pour la réduction ciblée des valeurs stockées dans des accumulateurs numériques (7, 8) du dispositif de commande (53) lorsque la valeur limite la plus élevée (N₀, N₁, N₂) est dépassée.

5. Convertisseur selon l'une des revendications précédentes,
**caractérisé en ce que** le dispositif de commande (53) est conçu pour traiter par voie numérique les flux de bits (1, 2, 3, 30, 31, 32) fournis comme signal d'entrée avec des flux de bits (54) dérivés des signaux de sortie renvoyés du dispositif de commande (53), chaque flux de bits (1, 2, 3, 30, 31, 32) fourni comme signal d'entrée étant associé à un flux de bits (54) de la sortie de puissance respective (52) dérivé d'un signal de sortie renvoyé du dispositif de commande,
le convertisseur (50) comprenant des modulateurs delta-sigma (19, 20, 21, 23, 24, 25) pour générer les flux de bits (54) dérivés des signaux de sortie renvoyés du dispositif de commande, les modulateurs delta-sigma (19, 20, 21, 23, 24, 25) étant conçus pour convertir les tensions et/ou les courants analogiques délivrés aux sorties de puissance en des flux de bits ayant la largeur d'un bit.

6. Convertisseur selon l'une des revendications précédentes,
**caractérisé en ce que** le convertisseur (50) est conçu pour la régulation des courants délivrés par les sorties de puissance.

7. Convertisseur selon l'une des revendications précédentes,
**caractérisé en ce que** le dispositif de commande (53) comporte une unité de régulation (15) qui est conçue pour déterminer la fréquence de commutation moyenne des signaux de sortie des sorties de puissance (52) et pour effectuer une régulation de la fréquence de commutation moyenne à une valeur de consigne prédéterminée.

8. Convertisseur selon l'une des revendications précédentes,
**caractérisé en ce que** le dispositif de commande (53) comporte du côté entrée un décodeur quantique (4, 29) en combinaison avec une table d'incrémentation qui est conçue pour décoder en quanta les flux de bits (1, 2, 3, 30, 31, 32) fournis comme signal d'entrée et pour en faire la somme par incréments avec le signe correct.

9. Convertisseur selon la revendication précédente,
**caractérisé en ce que** le dispositif de commande (53) comporte au moins deux accumulateurs numériques (7, 8) qui sont connectés en aval de la table d'incrémentation, les accumulateurs numériques (7, 8) étant conçus pour faire la somme des incréments délivrés par la table d'incrémentation.

10. Convertisseur selon l'une des revendications précédentes,
**caractérisé en ce que** le dispositif de commande (53) est conçu pour générer des signaux de commande (P₁, P₂) des commutateurs à semi-conducteur (51) en fonction du flux de bits ou des flux de bits (1, 2, 3, 30, 31, 32) à l'aide d'un mécanisme de commutation qui est conçu pour générer des séquences de commutation des signaux d'actionnement (P₁, P₂) par lesquels la charge sur les commutateurs à semi-conducteur (51) est répartie uniformément sur les commutateurs à semi-conducteur (51) en moyenne temporelle,
**caractérisé en ce que**
le dispositif de commande (53) comprend une table de commutation (9).

11. Convertisseur selon l'une des revendications précédentes,
**caractérisé en ce que** le dispositif de commande (53) est conçu pour traiter par voie numérique le flux de bits (1, 2, 3, 30, 31, 32) fourni comme signal d'entrée ou les flux de bits (1, 2, 3, 30, 31, 32) fournis comme signal d'entrée avec des flux de bits (54) dérivés des signaux de sortie renvoyés du dispositif de commande (53),
le convertisseur (50) comprenant des modulateurs delta-sigma (19, 20, 21, 23, 24, 25) pour générer les flux de bits (54) dérivés des signaux de sortie renvoyés du dispositif de commande, les moyens de génération de flux de bits (19, 20, 21, 23, 24, 25) étant conçus pour convertir les tensions et/ou les courants analogiques délivrés aux sorties de puissance en des flux de bits ayant la largeur d'un bit.

12. Convertisseur selon la revendication précédente,
**caractérisé en ce que** le dispositif de commande (53) présente une ou plusieurs valeurs limites (N₁, N₂), le dispositif de commande (53) présentant un comparateur qui est conçu pour comparer la valeur additionnée dans l'accumulateur numérique (7, 8) ou pour comparer une valeur déterminée à partir de celle-ci avec la valeur limite ou les valeurs limites (N₁, N₂) et pour déclencher une fonction de commutation dans le cas où une telle valeur limite (N₁, N₂) est alors dépassée.

13. Convertisseur selon la revendication précédente,
**caractérisé en ce que** le dispositif de commande (53) est conçu pour modifier de manière variable la valeur limite ou les valeurs limites (N₁, N₂) en fonction du signal de consigne respectif fourni comme signal d'entrée, et/ou en fonction de la valeur additionnée dans l'accumulateur numérique (7, 8) ou d'une valeur déterminée à partir de celle-ci.

14. Programme informatique pour commander un convertisseur multiphasé (50) pour délivrer un courant alternatif multiphasé, le convertisseur (50) ayant pour chaque phase du courant alternatif multiphasé une sortie de puissance (52) commandée par au moins deux commutateurs à semi-conducteur montés dans un circuit en demi-pont, le programme informatique comprenant des moyens de code de programme conçus pour mettre en œuvre le procédé suivant lorsque le programme informatique est exécuté sur un calculateur du convertisseur (50) :
- traiter un signal de consigne fourni au convertisseur (50) comme signal d'entrée sous la forme d'un flux de bits (1, 2, 3, 30, 31, 32) ayant la largeur d'un bit ou de plusieurs bits, pour chaque phase, flux dans lequel l'information y contenue est représentée par une valeur moyenne sur une succession de bits successifs du flux de bits,
- générer des signaux d'actionnement (P₁, P₂, P₃) des commutateurs à semi-conducteur en fonction des flux de bits (1, 2, 3, 30, 31, 32) fournis en tant que signal d'entrée à l'aide d'une modulation du vecteur spatial,
dans lequel
la modulation du vecteur spatial présente une hystérésis angulaire et/ou une hystérésis de valeur du vecteur spatial de tension,
il existe un mécanisme de commutation pour générer des séquences de commutation de la modulation du vecteur spatial, qui, en plus des bits d'état qui correspondent aux signaux de commutation de sortie et donc aux signaux d'actionnement (P₁, P₂, P₃) des commutateurs à semi-conducteur (51), présente au moins un bit supplémentaire sous la forme d'un bit de cycle qui indique le sens du mouvement dans le cycle du vecteur spatial de tension, et
l'hystérésis angulaire est réalisée à l'aide du bit de cycle.

15. Programme informatique selon l'une des revendications précédentes, **caractérisé par** l'étape consistant à :
- générer des signaux d'actionnement (P₁, P₂) des commutateurs à semi-conducteur en fonction du flux de bits ou des flux de bits (1, 2, 3, 30, 31, 32) en générant des séquences de commutation des signaux d'actionnement (P₁, P₂) par lesquelles la charge sur les commutateurs à semi-conducteur (51) est répartie uniformément sur les commutateurs à semi-conducteur (51) en moyenne temporelle,
dans lequel
en plus des bits d'état correspondant aux signaux de commutation de sortie et donc aux signaux d'actionnement (P₁, P₂) des commutateurs à semi-conducteur (51), on détermine au moins un bit supplémentaire sous la forme d'un bit de cycle par lequel la charge des commutateurs à semi-conducteur (51) est répartie uniformément sur les commutateurs à semi-conducteur (51) en moyenne temporelle.
